(19) Europäisches Patentamt European Patent Office Office européen des brevets

(11) **EP 4 760 857 A2**

(12) **EUROPEAN PATENT APPLICATION**

(43) Date of publication:
**17.06.2026 Bulletin 2026/25**

(21) Application number: **25221469.7**

(22) Date of filing: **08.12.2025**

(51) International Patent Classification (IPC):
*H01M 10/42* (2006.01)      *G01R 31/367* (2019.01)
*G01R 31/378* (2019.01)      *G01R 31/382* (2019.01)
*H01M 10/48* (2006.01)      *H01M 4/58* (2010.01)

(52) Cooperative Patent Classification (CPC):
**H01M 10/425; G01R 31/367; G01R 31/378;
G01R 31/382; H01M 10/4285; H01M 10/48;
H01M 4/5825**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH LA MA MD TN**

(30) Priority: **13.12.2024 KR 20240186276**

(71) Applicant: **SAMSUNG SDI CO., LTD.
Yongin-si, Gyeonggi-do 17084 (KR)**

(72) Inventor: **Kim, Hwasu
Yongin-si, Gyeonggi-do 17084 (KR)**

(74) Representative: **Meissner Bolte Partnerschaft
mbB
Patentanwälte Rechtsanwälte
Postfach 86 06 24
81633 München (DE)**

(54) **DEVICE AND METHOD FOR DETECTING BATTERY CONDITION**

(57)    A device for detecting a battery condition (10) may include a storage device (11) storing a battery model (111) that models a voltage change and an internal impedance of a battery (20) as an electrical circuit, and a control device (13) configured to estimate a distribution status of lithium ions in a positive electrode active material of the battery (20), detect a distortion zone remaining in a boundary portion of two identical-phase regions in the positive electrode active material based on the distribution status, estimate an overvoltage caused by the distortion zone, correct the battery model (111) by using a correction parameter corresponding to the overvoltage, and estimate a condition of the battery (20) by using the battery model (111).

## FIG. 1

## Description

### FIELD

The present disclosure relates to a device and method for detecting a battery condition, and more particularly, the present disclosure relates to a device and method for detecting a battery condition of a lithium iron phosphate (LiFePO$_4$) battery.

### BACKGROUND

A rechargeable battery is a battery that may be charged and discharged, unlike a primary battery that may not be charged. Low-capacity rechargeable batteries are used in portable small electronic devices such as smartphones, feature phones, laptop computers, digital cameras, and camcorders, and large-capacity rechargeable batteries are widely used as motor driving power and power storage devices such as hybrid vehicles and electric vehicles. The rechargeable battery includes an electrode assembly including a positive electrode and a negative electrode, a case accommodating the electrode assembly, and an electrode terminal connected to the electrode assembly.

In general, the rechargeable battery includes an electrode assembly including a positive electrode, a negative electrode, and a separator interposed between the positive and negative electrodes; a case accommodating the electrode assembly; and an electrode terminal electrically connected to the electrode assembly. An electrolyte solution is injected into the case to enable charging and discharging of the battery through an electrochemical reaction between the positive electrode, the negative electrode, and the electrolyte solution. A shape of the case, such as a cylindrical or rectangular shape, depends on the purpose of the battery.

The lithium iron phosphate (LiFePO$_4$) battery, which is a type of lithium ion battery, is a secondary battery that uses lithium iron phosphate (LiFePO$_4$) with an olivine structure as a positive electrode active material.

The herein information disclosed in this background section is only for enhancement of understanding of the background of the disclosure, and therefore it may contain information that does not form the prior art that is already known in this country to a person of ordinary skill in the art.

### SUMMARY

The present disclosure attempts to provide a device and method for detecting a battery condition for improving the accuracy of detecting a battery condition by reflecting overvoltage due to memory effect in a battery model of a lithium iron phosphate (LiFePO$_4$) battery.

However, the technical problem to be solved by the present disclosure is not limited to the herein, and other objects not mentioned herein will be understood from the following description by those skilled in the art.

A device for detecting a battery condition includes a storage device storing a battery model that models a voltage change and an internal impedance of a battery as an electrical circuit, and a control device configured to estimate a distribution status of lithium ions within a positive electrode active material of the battery, detect a distortion zone remaining in a boundary portion of two identical-phase regions in the positive electrode active material based on the distribution status, estimate an overvoltage caused by the distortion zone, correct the battery model by using a correction parameter corresponding to the overvoltage, and estimate a condition of the battery by using the battery model.

The positive electrode active material may include LiFePO$_4$. The distribution status may include a distribution status within a positive electrode active material particle of a Li-rich phase region including a Li$_x$FePO$_4$ ($x \geq 0.9$) phase and a Li-poor phase region including a Li$_y$FePO$_4$ ($y \leq 0.05$) phase. The two identical-phase regions may be two Li-rich phase regions or two Li-poor phase regions.

The control device may be configured to model a region between an outer boundary and a center of the positive electrode active material particle as a one-dimensional coordinate system, estimate position information within the positive electrode active material particle of the Li-rich phase region and the Li-poor phase region by using the one-dimensional coordinate system.

The control device may be configured to estimate a first distance between the two Li-rich phase regions, or a second distance between the two Li-poor phase regions based on the position information. The control device may be configured to determine that the distortion zone is formed in a boundary portion between the two Li-rich phase regions, if the first distance decreases below a threshold value during a constant current discharge. The control device may be configured to determine that the distortion zone is formed in a boundary portion between the two Li-poor phase regions, if the second distance decreases below the threshold value during a constant current charge.

The control device may be configured to determine that the distortion zone has been eliminated, if the distortion zone exists in a boundary portion of the two Li-rich phase regions, if the distortion zone is completely transitioned to the Li-rich phase region by discharging or the distortion zone is transitioned to the Li-poor phase region by charging.

The control device may be configured to determine that the distortion zone has been eliminated, if the distortion zone exists in a boundary portion of the two Li-poor phase regions, if the distortion zone is completely transitioned to the Li-poor phase region by charging or the distortion zone is completely transitioned to the Li-rich phase region by discharging.

The control device may be configured to estimate the position information of the distortion zone by using the one-dimensional coordinate system. The control device may be configured to predict a state-of-charge (SOC) at which lithium ions are deintercalated from or intercalated into the distortion zone in a subsequent charge or discharge section, based on the position information of the distortion zone.

The control device may be configured to determine the overvoltage by using a first overvoltage estimated by using a first overvoltage function and a second overvoltage estimated by using a second overvoltage function. The first overvoltage function may be a normal distribution function centered on the SOC, which derives the first overvoltage occurring in the distortion zone for each SOC of the battery. the second overvoltage function may be an exponential function, which derives the second overvoltage occurring in the distortion zone for each SOC of the battery.

The storage device may be configured to store a function table including a plurality of first overvoltage functions and a plurality of second overvoltage functions corresponding to different charging and discharging conditions. The control device may be configured to select the first overvoltage function and the second overvoltage function from the function table depending on a present charging and discharging condition of the battery.

The correction parameter may include a correction resistance or a correction voltage. The control device may be configured to add the correction resistance or the correction voltage to internal parameters of the battery model.

A method for detecting a battery condition includes recording a distribution status of lithium ions within a positive electrode active material according to a charging and discharging history of the battery, detecting a distortion zone remaining in a boundary portion of two identical-phase regions in the positive electrode active material based on the distribution status, estimating an overvoltage caused by the distortion zone, correcting a battery model of the battery by using a correction parameter corresponding to the overvoltage, and estimating a condition of the battery by using the battery model. The battery model may model a voltage change and an internal impedance of the battery as an electrical circuit.

The positive electrode active material may include $LiFePO_4$. The distribution status may include a distribution status within a positive electrode active material particle of a Li-rich phase region including a $Li_xFePO_4$ ($x \geq 0.9$) phase and a Li-poor phase region including a $Li_yFePO_4$ ($y \leq 0.05$) phase. The two identical-phase regions may be two Li-rich phase regions or two Li-poor phase regions.

The recording may include estimating position information within the positive electrode active material particle of the Li-rich phase region and the Li-poor phase region by using one-dimensional coordinate system modeling a region between an outer boundary and a center of the positive electrode active material particle.

The detecting the distortion zone may include estimating a first distance between the two Li-rich phase regions, or a second distance between the two Li-poor phase regions based on the position information, determining that the distortion zone is formed in a boundary portion between the two Li-rich phase regions, if the first distance decreases below a threshold value during a constant current discharge, and determining that the distortion zone is formed in a boundary portion between the two Li-poor phase regions, if the second distance decreases below the threshold value during a constant current charge.

The method may further include determining that the distortion zone has been eliminated, if the distortion zone exists in a boundary portion of the two Li-rich phase regions, if the distortion zone is completely transitioned to the Li-rich phase region by discharging or the distortion zone is transitioned to the Li-poor phase region by charging.

The method may further include determining that the distortion zone has been eliminated, if the distortion zone exists in a boundary portion of the two Li-poor phase regions, if the distortion zone is completely transitioned to the Li-poor phase region by charging or the distortion zone is completely transitioned to the Li-rich phase region by discharging.

The method may further include estimating the position information of the distortion zone by using the one-dimensional coordinate system, and predicting a SOC at which lithium ions are deintercalated from or intercalated into the distortion zone in a subsequent charge or discharge section, based on the position information of the distortion zone.

The estimating the overvoltage may include estimating a first overvoltage by using a first overvoltage function, estimating a second overvoltage by using a second overvoltage function, and determining the overvoltage by adding the first overvoltage and the second overvoltage. The first overvoltage function may be a normal distribution function centered on the SOC, which derives the first overvoltage occurring in the distortion zone for each SOC of the battery. The second overvoltage function may be an exponential function, which derives the second overvoltage occurring in the distortion zone for each SOC of the battery.

The correction parameter may include a correction resistance or a correction voltage. The correcting may include correcting the battery model by adding the correction resistance or the correction voltage to internal parameters of the battery model.

According to the present disclosure, the accuracy of a battery model can be improved by reflecting overvoltage due to memory effect in a battery model of a lithium iron phosphate ($LiFePO_4$) battery. In addition, the condition value of a

lithium iron phosphate ($LiFePO_4$) battery may be detected by using the battery model with improved accuracy, thereby improving accuracy of detecting battery condition.

However, effects obtainable through the present disclosure are not limited to the herein, and other effects not mentioned herein will be clearly understood by those skilled in the art from the following disclosure.

## BRIEF DESCRIPTION OF THE DRAWINGS

The accompanying drawings illustrate a preferred embodiment of the present disclosure and together with the foregoing disclosure, serve to provide further understanding of the technical features of the present disclosure, and thus, the present disclosure is not construed as being limited to the drawing.

FIG. 1 shows an example of an equivalent circuit model of a battery.
FIG. 2 schematically shows a battery system according to embodiments.
FIG. 3A to FIG. 3D show examples of modeling a distribution status of lithium ions within a positive electrode active material particle of a battery.
FIG. 4A to FIG. 4D show examples in which the distribution status of lithium ions within a positive electrode active material particle changes according to a charging and discharging history.
FIG. 5A to FIG. 5D are drawings for explaining a method by which a device for detecting a battery condition according to embodiments records a distribution status of lithium ions within the positive electrode active material particle.
FIG. 6A to FIG. 6D show examples in which a residual zone occurs within a positive electrode active material particle.
FIG. 7A and FIG. 7B are drawings for explaining a method by which a device for detecting a battery condition according to embodiments detects a residual zone.
FIG. 8A and FIG. 8B are drawings for explaining a tendency for overvoltage to occur due to a residual zone.
FIG. 9A and FIG. 9B show examples of defining an additional overvoltage occurring due to a residual zone by using two voltage curves.
FIG. 10A and FIG. 10B show examples in which a device for detecting a battery condition according to embodiments corrects a battery model.
FIG. 11 schematically shows a method for detecting a battery condition according to embodiments.

## DETAILED DESCRIPTION

Hereinafter, embodiments of the present disclosure will be described in detail with reference to the accompanying drawings. Prior to description, it should be understood that terms and words used in the specification and the appended claims should not be construed as having common and dictionary meanings, but should be interpreted as having meanings and concepts corresponding to technical ideas of the present disclosure in view of the principle that the inventor can properly define the concepts of the terms and words in order to describe his/her own disclosure as best as possible. Accordingly, since embodiment described in the specification and the configurations shown in the drawings are merely the most preferable embodiment and configurations of the present disclosure, they do not represent all of the technical ideas of the present disclosure, and it should be understood that that various equivalents and modified examples, which may replace the embodiments, are possible when filing the present application. It will be further understood that the terms "comprise, include," "comprising," and/or "including," when used in this specification, specify the presence of the stated features, integers, steps, operations, elements, and/or components but do not preclude the presence or addition of one or more other features, integers, steps, operations, elements, components, and/or groups thereof. The use of "can/may" in describing embodiments of the present disclosure may include "one or more embodiments of the present disclosure."

In addition, in order to help understanding of the present disclosure, the accompanying drawings are not drawn to scale, and the dimensions of some components may be exaggerated. In addition, the same reference numerals may be assigned to the same elements in different embodiments.

When it is explained that two objects are 'identical', this means that these objects are 'substantially identical'. Accordingly, the substantially identical objects may include deviations considered low in the art, for example, deviations within 5 %. In addition, when it is explained that certain parameters are uniform in a predetermined region, this may mean that the parameters are uniform in terms of an average in the corresponding region.

Although the terms "first", "second", and the like are used to describe various constituent elements, these constituent elements are not limited by these terms. These terms are used to distinguish one element from another, and unless stated to the contrary, a first element may be a second element.

Throughout the specification, unless stated otherwise, each element may be singular or plural.

When an element is "above (or under)" or "on (or below)" another element, the element can be on an upper surface (or a lower surface) of the other element, and intervening elements may be present between the element and the other element on (or below) the element.

In addition, when an element is referred to as being "connected", "coupled" or "linked" to another element, the element can be directly connected or coupled to the other element, but it should be understood that intervening elements may be present between each element, or each element may be "connected", "coupled" or "linked" to each other through another element. When one element is referred to as being coupled (e.g., electrically coupled or connected) to another element, the one element may be directly coupled to that another element or indirectly coupled to that another element via one or more intervening elements.

Throughout the specification, unless stated otherwise, "A and/or B" refers to A, B, or A and B. In other words, the term "and/or" includes all or various combinations of a plurality of items that are related and arranged. "C to D" refers to C or greater and D or smaller, unless stated otherwise.

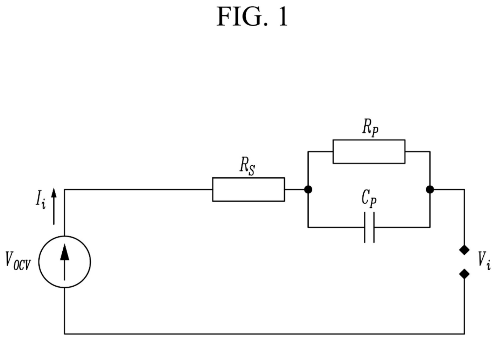

FIG. 1 shows an example of an equivalent circuit model (ECM) of a battery.

Referring to FIG. 1, the ECM is a battery model in which an internal impedance and a voltage change of the battery is simplified as an electrical circuit. Parameters constituting the ECM may include an open circuit voltage (OCV) Vocv, series resistance Rs, and a parallel impedance (a parallel resistance Rp, and a parallel capacitance Cp). The series resistance Rs represents an Ohmic resistance inside the battery, and is related to a voltage drop phenomenon at the time of discharging the battery and a voltage rise phenomenon at the time of charging the battery. The parallel resistance Rp and the parallel capacitance Cp represent the charge transfer resistance and the charge transfer capacitance, respectively, and is related to the dynamic characteristics of the battery.

A lithium iron phosphate (LiFePO$_4$, hereinafter, referred to as 'LFP')) battery has various unique characteristics in comparison with other lithium ion batteries using cobalt, nickel, manganese, or the like as a positive electrode active material. In the LFP battery, lithium ions (Li$^+$) are deintercalated or intercalated during the process of charging or discharging the battery, so that a lithium-rich Li$_x$FePO$_4$ (x $\geq$ 0.9) phase and a lithium-poor Li$_y$FePO$_4$ (y $\leq$ 0.05) phase coexist in the positive electrode, thereby having a two-phase transition characteristic in which transition occurs between the two phases. These two-phase transition characteristics may be expressed by the following reaction formula.

[Reaction formula] $\qquad Li_xFePO_4 \leftrightarrow Li_yFePO_4 + (x - y)Li^+ + (x - y)e^-$

In the above reaction formula, Li$^+$ and e$^-$ represent lithium ions and electrons, respectively, and x and y represent composition ranges. The composition range refers to a range over which the relative ratios of corresponding constituent elements in a particular compound can vary. Hereinafter, for better understanding and ease of description, the Li$_x$FePO$_4$ phase is referred to as a 'Li-rich phase', and the Li$_y$FePO$_4$ phase is referred to as a 'Li-poor phase'. The Li-rich phase may include a state in which lithium ions are maximally intercalated so that x becomes 1 (i.e., LiFePO$_4$). In addition, the Li-poor phase may include a state in which lithium ions are completely deintercalated so that y becomes 0 (i.e., FePO$_4$).

In the LFP battery, according to the structural difference between the Li-rich phase and the Li-poor phase, a distortion zone may be formed within the positive electrode active material in the transition process between two phases. During the transition process between the Li-rich phase and the Li-poor phase, different orientations and volume changes may occur due to the structural difference between the two phases, so that the crystal structure may not transition smoothly and a distortion zone may occur.

During the charging and discharging process of the LFP battery, a concentration gradient may occur within the positive electrode active material due to deintercalation or intercalation of lithium ions, and the concentration gradient may become severe as the deintercalation/intercalation rate of lithium ions increases. That is, compared to constant voltage (CV) charging and CV discharging in which the deintercalation/intercalation rate of lithium ions is relatively low, the concentration gradient may become severe at the time of constant current (CC) charging and CC discharging in which the deintercalation/intercalation rate of lithium ions is high. As the concentration gradient becomes severe during the transition process between the two phases, the movement speed and phase transition of lithium ions within the positive electrode active material may become non-uniform, so that the distortion zone may become severe. The distortion zone may gradually decrease and be resolved as the phase transition progresses and the lithium ion concentration within respective phase regions becomes uniform.

Meanwhile, the LFP battery may exhibit a memory effect characteristic in which the distortion zone is not eliminated but remains at a boundary portion between two phase regions (between two Li-rich phase regions, or between two Li-poor phase regions) having an identical phase within the positive electrode active material, when a charging and discharging history (or charging and discharging path) meets a certain condition. The distortion zone remaining due to the memory effect characteristic (hereinafter, referred to as 'a residual zone') may generate an additional overvoltage when the LFP battery is charged or discharge afterwards. In a section in which the identical phase continues, that is, a section in which the Li-rich phase region continues or the Li-poor phase continues, an activation energy barrier is low, so that continuous deintercalation/intercalation of lithium ions is possible with only a small amount of energy during charging or discharging. However, when charging or discharging continues and phase transition starts to occur in the residual zone, (i.e., when lithium ions begin to be intercalated or deintercalated in the residual zone), the additional overvoltage may occur due to the changed activation energy barrier, and a voltage behavior of the LFP battery may be affected.

In the embodiments described herein, the accuracy of the battery model can be improved by predicting the additional overvoltage caused due to the memory effect characteristics of the LFP battery, and reflecting the predicted overvoltage into the battery model.

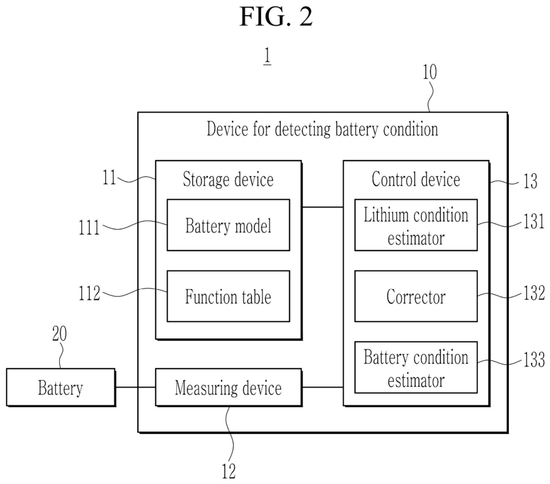

FIG. 2 schematically shows a battery system according to embodiments.

Referring to FIG. 2, a battery system 1 may include a battery 20, and a device 10 for detecting a battery condition.

The battery 20 may be the LFP battery (or the LFP battery cell) using the LFP as a positive electrode active material.

The device 10 for detecting a battery condition may measure voltage, current, temperature, or the like of the battery 20, and may predict a state-of-charge (SOC), a state-of-health (SOH), the open circuit voltage (OCV), internal resistance, or the like, of the battery 20 by using the measurement values and the battery model 111. The device 10 for detecting a battery condition may include a storage device 11, a measuring device 12, and a control device 13.

The storage device 11 may store information, data, or the like, processed by the device 10 for detecting a battery condition.

The storage device 11 may store the battery model 111. The battery model 111 may simulate electric properties (the internal impedance, the voltage change, or the like) of the battery 20 by using OCV, resistance, capacitance, or the like. For example, the battery model 111 may include the ECM described with reference to FIG. 1. The storage device 11 may store the battery model 111 by storing parameter values (see Vocv, Rs, Rp, and Cp of FIG. 1) constituting the battery model 111 in the form of a table or function according to the charging and discharging condition (temperature, the SOC, the SOH, or the like).

The storage device 11 may store the overvoltage function table. The overvoltage function table may include the overvoltage functions used for estimating an overvoltage value caused due to the memory effect characteristics of the battery 20.

The storage device 11 may store a program for operating the control device 13 described later.

The storage device 11 may include at least one memory (not shown). The memory may be a computer-readable recording medium, and include various forms of volatile or non-volatile recording media. The memory may include various forms of recording media such as a flash memory type, a hard disk type, a card type (e.g., SD or XD memory), a random access memory (RAM), a static random-access memory (SRAM), a read-only memory (ROM), an electrically erasable programmable read-only memory (EEPROM), a programmable read-only memory (PROM).

The measuring device 12 may periodically measure a condition value of the battery 20 such as voltage, current, temperature, or the like. The measuring device 12 may include at least one sensor, or measurement circuit for measuring the condition value of the battery 20. The measuring device 12 may be integrated as at least one analog front end (AFE) Integrated circuit (IC).

The control device 13 may control an overall operation of the device 10 for detecting a battery condition.

The control device 13 may obtain the measurement values (voltage, current, temperature, or the like) through the measuring device 12. The control device 13 may detect condition values such as SOC, SOH, OCV, internal resistance, or the like, of the battery 20, by using the measurement values and the battery model 111. The control device 13 may include a lithium condition estimator 131, a corrector 132, and a battery condition estimator 133.

The lithium condition estimator 131 may estimate a distribution status of lithium ions (or lithium-ion concentration profile) within the positive electrode active material of the battery 20.

In the battery 20 using the LFP as a positive electrode active material, the distribution status of lithium ions within the positive electrode active material may vary according to the charging and discharging history. The charging and discharging history represents the history of changes in the SOC of the battery 20 (or depth of discharge (DOD)) when charging and discharging the battery 20. When comparing the case where the battery 20 is continuously discharged from SOC 100% to the SOC 50% and the case where the battery 20 is continuously charged from SOC 0% to SOC 50%, the charging and discharging history until the SOC has reached 50% is different although discharging and charging of the battery 20 is terminated at the same SOC 50%. As such, when the charging and discharging history is different, the distribution statuses of lithium ions within the positive electrode active material may be different from each other even if the SOC of the battery 20 may be the same.

Therefore, the lithium condition estimator 131 may monitor the charging and discharging history of the battery 20 to estimate the distribution status of lithium ions within the positive electrode active material of the battery 20.

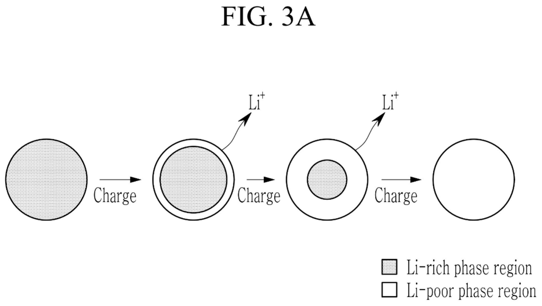

Hereinafter, the method by which the lithium condition estimator 131 estimates and record the distribution status of lithium ions within the positive electrode active material of the battery 20 will be described in detail with reference to FIG. 3A to FIG. 3D, FIG. 4A to FIG. 4D, and FIG. 5A to FIG. 5D.

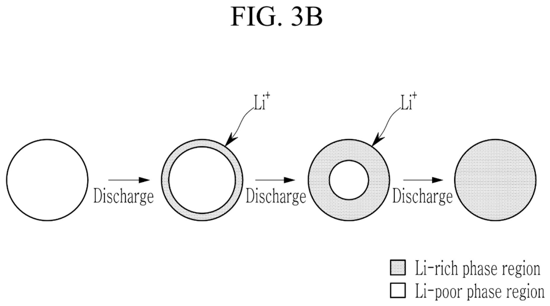

FIG. 3A and FIG. 3B show an example of modeling the distribution status of lithium ions inside a positive electrode active material particle of the battery 20. FIG. 3A and FIG. 3B are examples of modeling the distribution status of lithium ions within the positive electrode active material particle of a circular shape by using a radial modeling. FIG. 3A shows an example in which the distribution status of lithium ions within the positive electrode active material particle varies during charging, and FIG. 3B shows an example in which the distribution status of lithium ions within the positive electrode active material particle varies during discharging.

Referring to FIG. 3A, in a fully discharged state of the battery 20, only the Li-rich phase can exist within the positive electrode active material particle. Afterwards, when charging of the battery 20 progresses, lithium ions (Li$^+$) may be deintercalated from an outer boundary of the positive electrode active material particle and move to the negative electrode. In addition, the Li-poor phase region may be created on the outer side of the positive electrode active material particle, to cause a phase separation in which the Li-poor phase and the Li-rich phase exist on an outer boundary and a center of the positive electrode active material particle, respectively. As charging progresses, the Li-poor phase region may increase and a boundary (or interface) between the Li-poor phase region and the Li-rich phase region may gradually move toward the center of the positive electrode active material particle. When the battery 20 is fully charged, all lithium ions (Li$^+$) are released and migrate toward the negative electrode, so that only the Li-poor phase exists within the positive electrode active material particle.

Referring to FIG. 3B, in a fully charged state of the battery 20, only the Li-poor phase can exist within the positive electrode active material particle. Afterwards, when discharging of the battery 20 progresses, lithium ions (Li$^+$) may be intercalated from the outer boundary of the positive electrode active material particle. In addition, the Li-rich phase region may be created on the outer side of the positive electrode active material particle, to cause a phase separation in which the Li-rich phase and the Li-poor phase exist on the outer boundary and the center of the positive electrode active material particle, respectively. As discharging progresses, the Li-rich phase region may increase and the boundary (or interface) between the Li-rich phase region and the Li-poor phase region may gradually move toward the center of the positive electrode active material particle. When the battery 20 is fully discharged, the positive electrode active material particle may be fully filled with lithium ions (Li$^+$), so that only the Li-rich phase exist within the positive electrode active material particle.

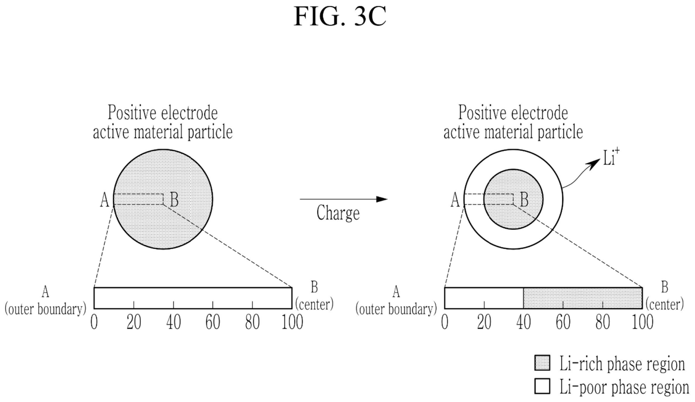

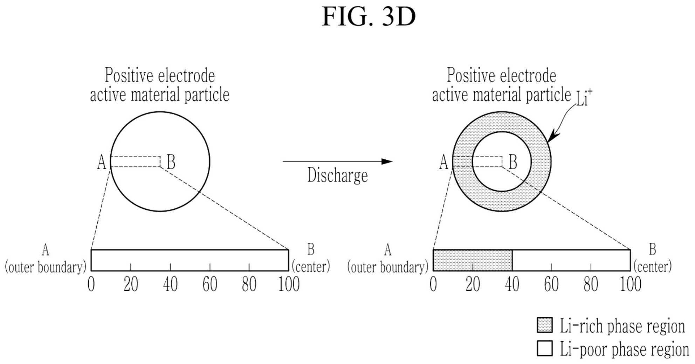

FIG. 3C and FIG. 3D show other examples of modeling the distribution status of lithium ions within the positive electrode active material particle of the battery 20. FIG. 3C and FIG. 3D are examples of modeling the distribution status of lithium ions within the positive electrode active material particle by using a bar graph. FIG. 3C shows an example in which the distribution status of lithium ions within the positive electrode active material particle varies during charging, and FIG. 3D shows an example in which the distribution status of lithium ions within the positive electrode active material particle varies during discharging.

In FIG. 3C and FIG. 3D, the bar graph is obtained by modeling the distribution status of lithium ions (Li$^+$) between the center and the outer boundary of the positive electrode active material particle through conversion into one-dimensional coordinate system. In the bar graph, a left-side end point A represents the outer boundary (surface) of the positive electrode active material particle, and a right-side end point B represents the center of the positive electrode active material particle. The coordinate values 0 to 100 in the bar graph may be a value representing a relative distance from the outer boundary of the positive electrode active material particle. Taking FIG. 3C and FIG. 3D as an example, in the bar graph, the coordinate value may decrease to the left side (i.e., closer to the outer boundary of the positive electrode active material particle), and the coordinate value may increase to the right side (i.e., closer to the center of the positive electrode active material particle). In addition, in the bar graph, the Li-rich phase region or the Li-poor phase region may be modeled to linearly increase or decrease depending on the amount of lithium ions intercalated or deintercalated. That is, in the bar graph, the Li-rich phase region or the Li-poor phase region may be modeled to be dependent on the SOC of the battery 20 and to linearly increase or decrease according to the change of the SOC of the battery 20. By using such bar graphs, the distribution status of lithium ions within the positive electrode active material particle may be converted into coordinate values. In addition, the history of the change of the distribution status of lithium ions within the positive electrode active material particle may be stored to correspond to the history of change of SOC of the battery 20.

Meanwhile, FIG. 3A to FIG. 3D illustrate the case in which the battery 20 is continuously charged from the fully discharged state to the fully charged state, or continuously discharged from the fully charged state to the fully discharged state. However, during actual use of the battery 20, a there may frequently be the case where only a fraction of the capacity of the battery 20 repeatedly charged and discharged.

Therefore, depending on the charging and discharging history of the battery 20, a plurality of boundaries between the Li-poor phase region and the Li-rich phase region may exist within the positive electrode active material particle.

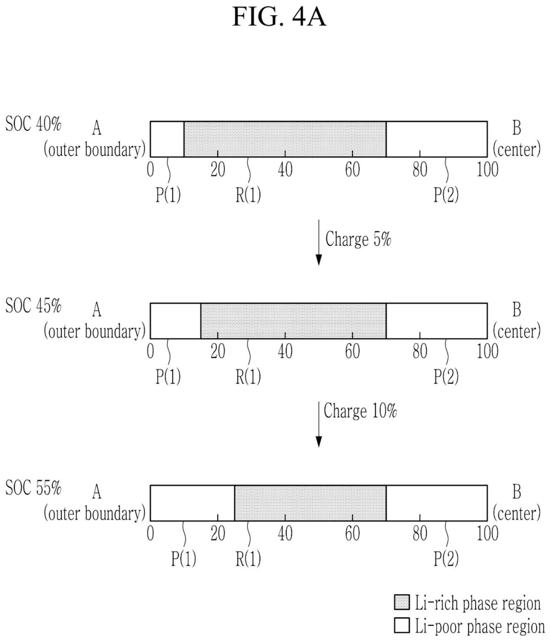

FIG. 4A to FIG. 4D are drawings for explaining how the distribution status of lithium ions changes within the positive electrode active material particle according to the charging and discharging history, and illustrate modeling of the distribution status of lithium ions by using the bar graph described with reference to FIG. 3C and FIG. 3D.

In FIG. 4A to FIG. 4D, R(i) and P(i) represent the Li-rich phase region and the Li-poor phase region, respectively, located at i-th locations from the outer boundary (surface) of the positive electrode active material particle.

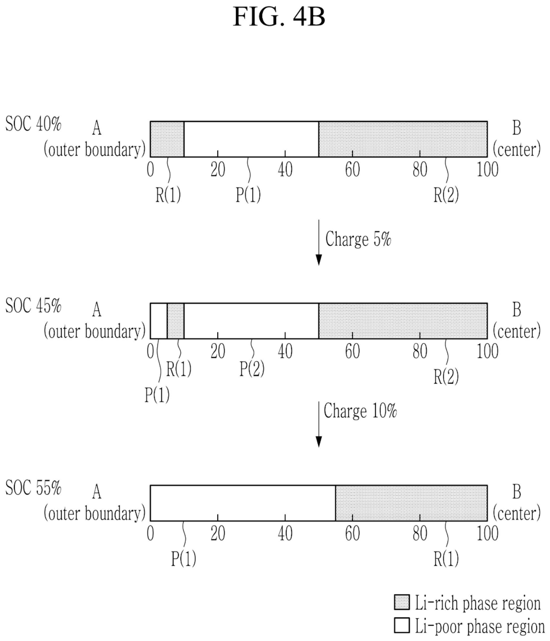

In FIG. 4A and FIG. 4B, the battery 20 may be charged from SOC 40% to SOC 55%. However, according to the difference of the charging and discharging history until reaching SOC 40%, the distribution of the Li-rich phase region and the Li-poor phase region appears to be different in FIG. 4A and FIG. 4B.

Referring to FIG. 4A, at SOC 40% of the battery 20, the Li-poor phase regions P(1) and P(2) may exist on the outer boundary (surface) and the center of the positive electrode active material particle, respectively, and the Li-rich phase region R(1) may exist between the two Li-poor phase regions P(1) and P(2). Afterwards, when charging of the battery 20 is initiated, lithium ions are released from the Li-rich phase region R(1), and accordingly, a boundary between the Li-poor phase region P(1) and the Li-rich phase region R(1) may gradually move toward the center of the positive electrode active material particle (see the bar graphs at SOC 45% and SOC 55%).

Referring to FIG. 4B, at SOC 40% of the battery 20, the Li-rich phase regions R(1) and R(2) may exist on the outer boundary (surface) and the center of the positive electrode active material particle, respectively, and the Li-poor phase region P(1) may exist between two Li-rich phase regions R(1) and R(2). Afterwards, when charging of the battery 20 is initiated, lithium ions are released from the outer boundary of the Li-rich phase region R(1), and the Li-poor phase region P(1) may be created on the outer boundary of the positive electrode active material particle (see the bar graph at SOC 45%). When charging continues and the SOC of the battery 20 exceeds 50%, all previous Li-rich phase regions R(1) may be transitioned to the Li-poor phase region P(1), and only one Li-poor phase region P(1) and one Li-rich phase region R(1) may exist in the outer boundary and the center of the positive electrode active material particle, respectively (see the bar graph at SOC 55%).

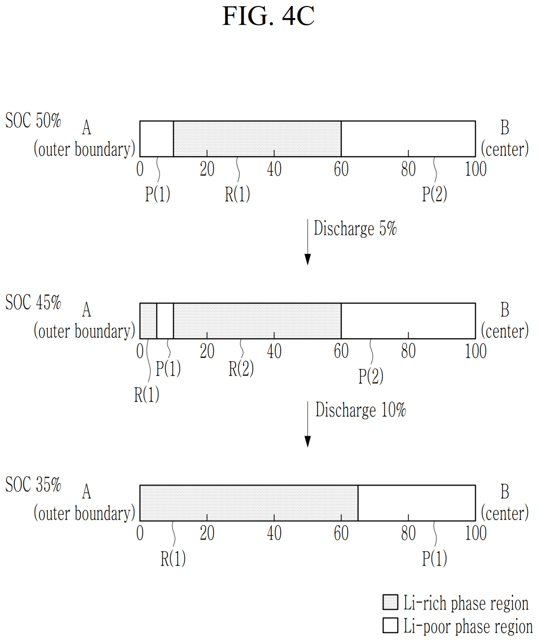

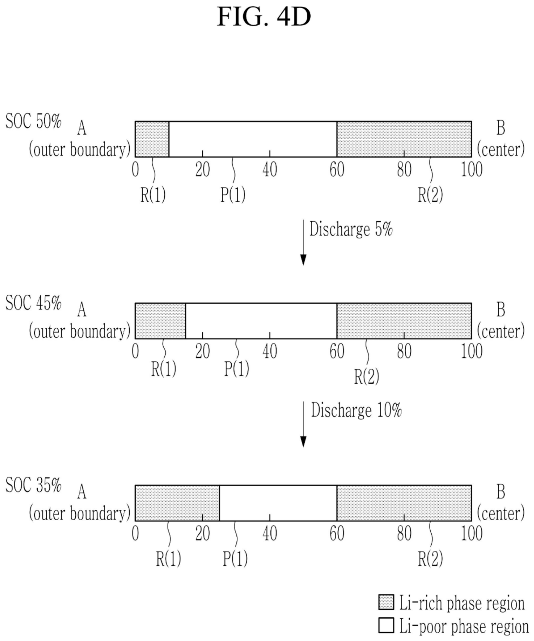

In FIG. 4C and FIG. 4D, the battery 20 may be discharged from SOC 50% to SOC 35%. However, according to the difference of the charging and discharging history until reaching SOC 50%, the distribution of the Li-rich phase region and the Li-poor phase region appears to be different in FIG. 4C and FIG. 4D.

Referring to FIG. 4C, at SOC 50% of the battery 20, the Li-poor phase regions P(1) and P(2) may exist on the outer boundary (surface) and the center of the positive electrode active material particle, respectively, and the Li-rich phase region R(1) may exist between the two Li-poor phase regions P(1) and P(2). Afterwards, when discharging of the battery 20 is initiated, the Li-rich phase region R(1) may be created on the outer boundary of the positive electrode active material particle due to intercalation of lithium ions (see the bar graph at SOC 45%). When discharging continues and the SOC of the battery 20 has decreased to be lower than 40%, all previous Li-poor phase regions P(1) may be transitioned to the Li-rich phase region R(1), and accordingly, only the one Li-rich phase region R(1) and the one Li-poor phase region P(1) may exist in the outer boundary and the center of the positive electrode active material particle, respectively (see the bar graph at SOC 35%).

Referring to FIG. 4D, at SOC 50% of the battery 20, the Li-rich phase regions R(1) and R(2) may exist on the outer boundary (surface) and the center of the positive electrode active material particle, respectively, and the Li-poor phase region P(1) may exist between the two Li-rich phase regions R(1) and R(2). Afterwards, when discharging of the battery 20 is initiated, due to intercalation of lithium ions, the boundary between the Li-rich phase region R(1) and the Li-poor phase region P(1) may gradually move toward the center of the positive electrode active material particle (see the bar graphs at SOC 45% and SOC 35%).

As discussed herein, even if the SOC of the battery 20 is in the same state, the distribution status of lithium ions within the positive electrode active material particle may vary depending on the path on which the battery 20 has previously experienced charging and discharging.

Therefore, the lithium condition estimator 131 may continuously monitor the charging and discharging history, that is, the SOC change history, of the battery 20 and record the distribution status of lithium ions within the positive electrode active material particle of the battery 20. The lithium condition estimator 131 may obtain position information representing the lithium ion distribution status by converting the estimated lithium ion distribution status into coordinate information. The lithium condition estimator 131 may store the position information obtained in such a way in the storage device 11 in correspondence with the corresponding SOC, to record the distribution status of lithium ions within the positive electrode active material particle.

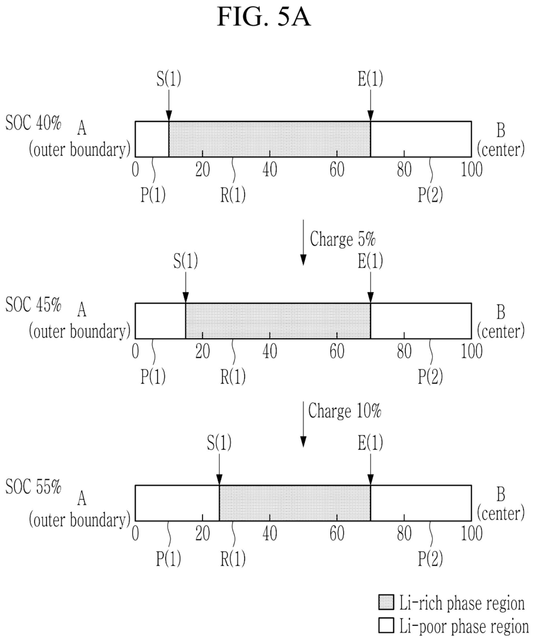

FIG. 5A to FIG. 5D are drawings for explaining a method by which the lithium condition estimator 131 records the distribution status of lithium ions within the positive electrode active material particle of the battery 20.

FIG. 5A to FIG. 5D illustrate examples of converting a region between the center and the outer boundary of the positive electrode active material particle into one-dimensional coordinate system in the bar graph format, and recording the position information (a starting position S(i) and an ending position E(i)) of each Li-rich phase region R(i) by using such one-dimensional coordinate system.

In the description herein, S(i) and E(i) are the position information of the Li-rich phase region R(i) located at i-th locations from the outer boundary of the positive electrode active material particle, and indicate the starting position and the ending position of the Li-rich phase region R(i), respectively. In addition, an i-th Li-rich phase region R(i) may mean the Li-rich phase region located i-th closet from the outer boundary (or surface) of the positive electrode active material particle, and an i-th Li-poor phase region P(i) may mean the Li-poor phase region located i-th closet from the outer boundary (or surface) of the positive electrode active material particle.

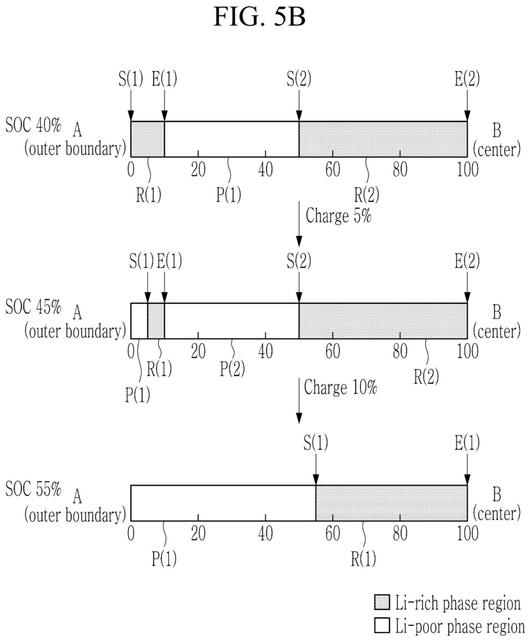

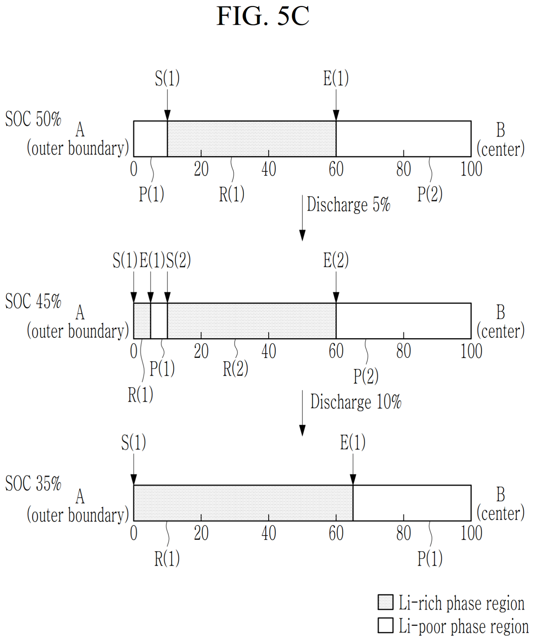

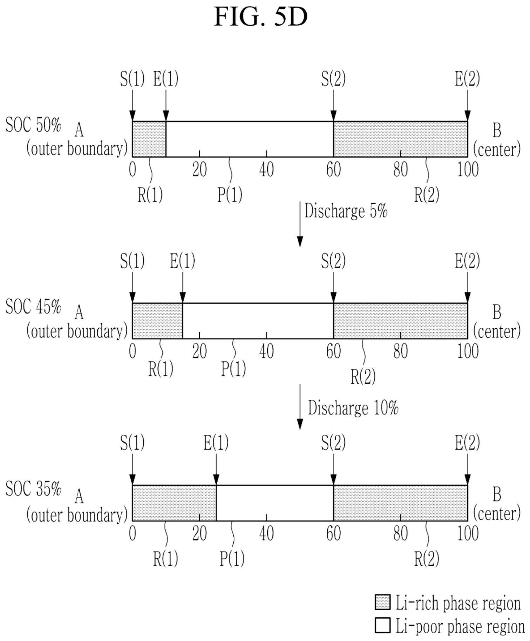

Taking FIG. 5A as an example, the position information of a 1st Li-rich phase region R(1) may be determined as (S(1), E(1)) = (10, 70) when SOC is 40%, as (S(1), E(1)) = (15, 70) when SOC is 45%, and as (S(1), E(1)) = (25, 70) when SOC is 55%. Taking FIG. 5B as an example, the position information of the 1st Li-rich phase region R(1) may be determined as (S(1), E(1)) = (0, 10) when SOC is 40%, as (S(1), E(1)) = (5, 10) when SOC is 45%, and as (S(1), E(1)) = (55, 100) when SOC is 55%, and the position information of a 2nd Li-rich phase region R(2) may be determined and as (S(2), E(2)) = (50, 100) when SOC is 40%, and as (S(2), E(2)) = (50, 100) when SOC is 45%. Taking FIG. 5C as an example, the position information of the 1st Li-rich phase region R(1) may be determined as (S(1), E(1)) = (10, 60) when SOC is 50%, as (S(1), E(1)) = (0, 5) when SOC is 45%, and as (S(1), E(1)) = (0, 65) when SOC is 35%, and the position information of the 2nd Li-rich phase region R(2) may be determined as (S(2), E(2)) = (10, 60) when SOC is 45%. Taking FIG. 5D as an example, the position information of the 1st Li-rich phase region R(1) may be determined as (S(1), E(1)) = (0, 10) when SOC is 50%, as (S(1), E(1)) = (0, 15) when SOC is 45%, and as (S(1), E(1)) = (0, 25) when SOC is 35%, and the position information of the 2nd Li-rich phase region R(2) may be determined and as (S(2), E(2)) = (60, 100) when SOC is 50%, as (S(2), E(2)) = (60, 100) when SOC is 45%, and as (S(2), E(2)) = (60, 100) when SOC is 35%.

When the position information (the starting position S(i) and the ending position E(i)) of each Li-rich phase region R(i) is determined, the lithium condition estimator 131may record this together with the corresponding SOC in the storage device 11. Accordingly, the SOC change history of the battery 20 and the history of change of the Li-rich phase region R(i) corresponding thereto may be recorded in the storage device 11.

In FIG. 5A to FIG. 5D, the distribution status of lithium ions within the positive electrode active material particle is recorded by recording the position information (the starting position S(i) and the ending position E(i)) of the Li-rich phase region R(i). However, in another embodiment, the distribution status of lithium ions within the positive electrode active material particle may be recorded by recording the position information (the starting position, the ending position) of the Li-poor phase region P(i), or by recording the position information of all of the Li-rich phase region R(i) and the Li-poor phase region P(i). When the Li-rich phase region and the Li-poor phase region coexist within the positive electrode active material particle, when the position information of one phase region is determined, the lithium condition estimator 131 may estimate the position information of a remaining phase region based on this.

The positive electrode of the battery 20 may include a plurality of positive electrode active material particles, and the lithium ion distribution status may be different for each positive electrode active material particle, even at the same time point. The lithium condition estimator 131 may estimate the distribution status of lithium ions with respect to one positive electrode active material particle in the manner described herein. Subsequently, the lithium condition estimator 131 may assume that the estimated lithium ion distribution status with respect to one positive electrode active material particle is an average lithium ion distribution status of the plurality of positive electrode active material particles included in the positive electrode of the battery 20.

When the distribution status of lithium ions within the positive electrode of the battery 20 is estimated, the lithium condition estimator 131 may check whether a remaining residual zone exists within the positive electrode of the battery 20 based on this.

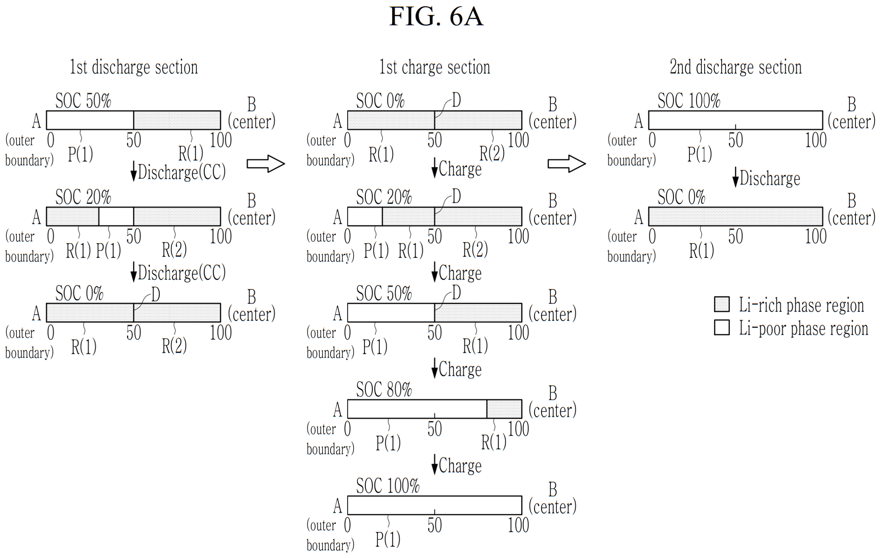

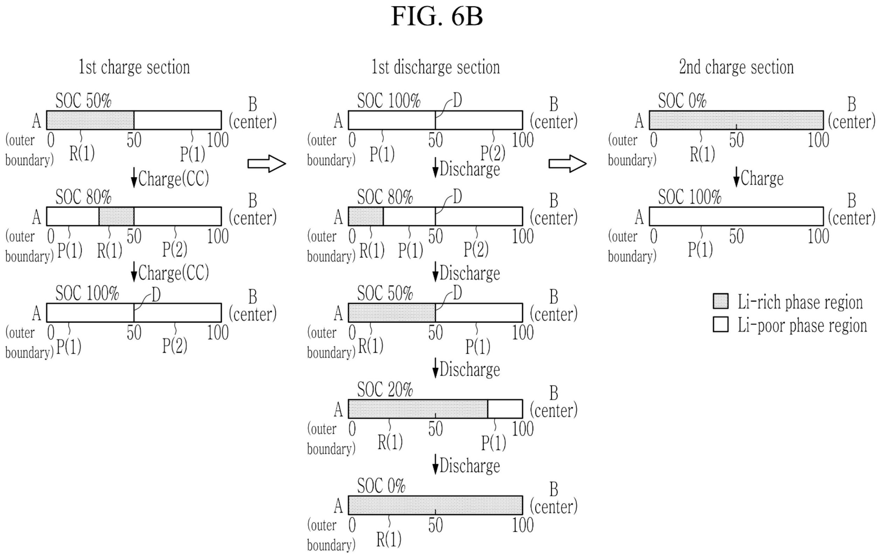

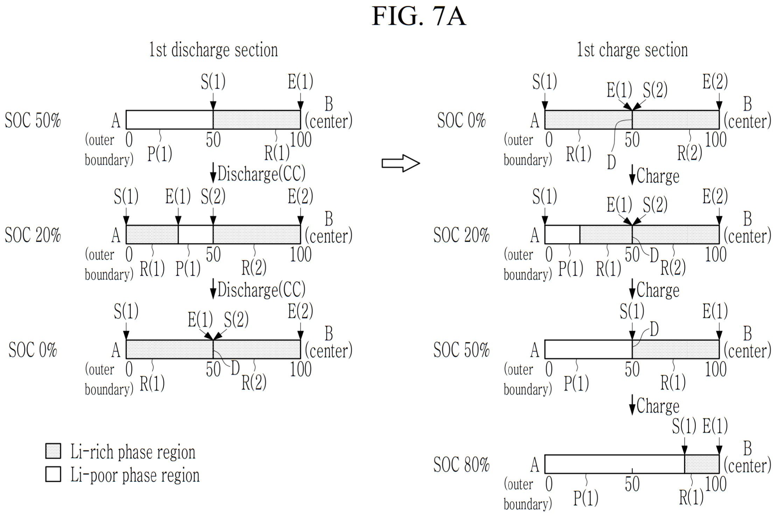

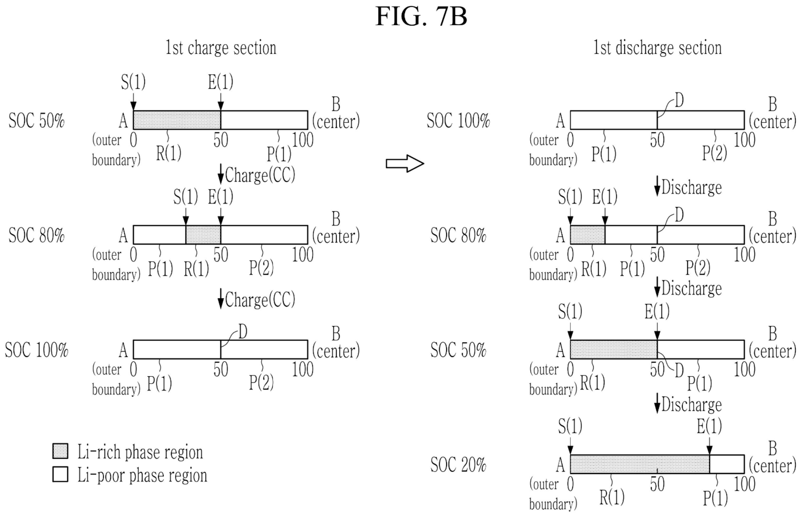

Hereinafter, the method in which the lithium condition estimator 131 detects the residual zone will be described in detail with reference to FIG. 6A and 6B, and FIG. 7A and 7B.

FIG. 6A to FIG. 6D show examples in which the residual zone occurs within the positive electrode active material particle of the battery 20. FIG. 6A to FIG. 6D may explain the lithium ion behavior within the positive electrode active material particle by using the bar graph described with reference to FIG. 3C and FIG. 3D.

Referring to FIG. 6A, first, in a 1st discharge section, the battery 20 may be discharged from SOC 50% to 0%. At SOC 50%, the Li-poor phase region P(1) and the Li-rich phase region R(1) may exist in the outer boundary and the center of the positive electrode active material particle of the battery 20, respectively. Afterwards, when discharging is initiated, the Li-rich phase region R(1) may be generated in the outer boundary of the positive electrode active material particle of the battery 20 due to intercalation of lithium ions. As discharging progresses, within the positive electrode active material particle of the battery 20, the Li-poor phase region P(1) may gradually transition to the Li-rich phase region R(1).

When the battery 20 CC discharged, due to the characteristic of CC discharging, when the distance between the neighboring two Li-rich phase regions R(1) and R(2) approaches within a predetermined distance, a residual zone D may be generated in the boundary portion between the two Li-rich phase regions R(1) and R(2). The residual zone D may occur as lithium ions are not sufficiently intercalated into the boundary portion between the two Li-rich phase regions R(1) and R(2) so that the Li-poor phase partially remains. Taking FIG. 6A as an example, even if the battery 20 is discharged to SOC 0%, due to the characteristic of CC discharging, the residual zone D may exist in the boundary portion between the two Li-rich phase regions R(1) and R(2).

In a 1st charge section that follows, the battery 20 may be charged from SOC 0% to SOC 100%. At SOC 0%, within the positive electrode active material particle of the battery 20, the two Li-rich phase regions R(1) and R(2) may exist in the outer boundary and the center of the positive electrode active material particle, respectively, and the residual zone D exists in the boundary portion between the two Li-rich phase regions R(1) and R(2). Afterwards, when charging is initiated, the Li-poor phase region P(1) may be generated in the outer boundary of the positive electrode active material particle of the battery 20 due to deintercalation of lithium ions. As charging progresses, the Li-rich phase region R(1) may gradually transition to the Li-poor phase region P(1). When charging continues and the SOC of the battery 20 becomes higher than 50%, all lithium ions may also be deintercalated from the residual zone D, and accordingly, the residual zone D may be converted into the Li-poor phase region P(1), thereby eliminating the residual zone D.

Therefore, in a 2nd discharge section that follows, while the battery 20 is being discharged again from SOC 100% to SOC 0%, the residual zone D may no longer exist within the positive electrode active material particle of the battery 20.

Referring to FIG. 6B, first, in the 1st charge section, the battery 20 may be charged from SOC 50% to 100%. At SOC 50%, the Li-poor phase region P(1) and the Li-rich phase region R(1) may exist in the center and the outer boundary of the positive electrode active material particle of the battery 20, respectively. Afterwards, when charging is initiated, the Li-poor phase region P(1) may be generated in the outer boundary of the positive electrode active material particle of the battery 20 due to deintercalation of lithium ions. As charging progresses, the Li-rich phase region R(1) may gradually transition to the Li-poor phase region P(1).

When the battery 20 CC charged, due to the characteristic of CC charging, when the distance between the neighboring two Li-poor phase regions P(1) and P(2) approaches within a predetermined distance, the residual zone D may occur in the boundary portion between the two Li-poor phase regions P(1) and P(2). The residual zone D may occur as lithium ions are not sufficiently released from the boundary portion between the two Li-poor phase regions P(1) and P(2) so that the Li-rich phase remains. Taking FIG. 6B as an example, even if the battery 20 is charged to SOC 100%, due to the characteristic of CC charging, the residual zone D may exist in the boundary portion between the two Li-poor phase regions P(1) and P(2).

In the 1st discharge section that follows, the battery 20 may be discharged from SOC 100% to SOC 0%. At SOC 100%, within the positive electrode active material particle of the battery 20, the two Li-poor phase regions P(1) and P(2) may exist in the outer boundary and the center of the positive electrode active material particle, respectively, and the residual zone D exists in the boundary portion between the two Li-poor phase regions P(1) and P(2). When discharging is initiated, the Li-rich phase region R(1) may be generated in the outer boundary of the positive electrode active material particle of the battery 20 due to intercalation of lithium ions. As discharging progresses, within the positive electrode active material particle, the Li-poor phase region P(1) may gradually transition to the Li-rich phase region R(1). When discharging continues and the SOC of the battery 20 becomes lower than 50%, lithium ions may also be sufficiently intercalated into the residual zone D, and accordingly, the residual zone D may be converted into the Li-rich phase region R(1), thereby eliminating the residual zone D.

Therefore, in a 2nd charge section that follows, while the battery 20 is being charged again from SOC 0% to SOC 100%, the residual zone D may no longer exist within the positive electrode active material particle of the battery 20.

Referring to FIG. 6A to FIG. 6B, when the two Li-rich phase regions R(1) and R(2) neighboring to each other are brought within a predetermined distance due by CC discharge, or when the two Li-poor phase regions P(1) and P(2) neighboring to each other are brought within a predetermined distance by CC charge, the residual zone D may be generated in the boundary portion between the two adjacent identical-phase regions. The residual zone D generated as such may be maintained until lithium ions are sufficiently filled in the residual zone D, or lithium ions are sufficiently released from the residual zone D, afterwards.

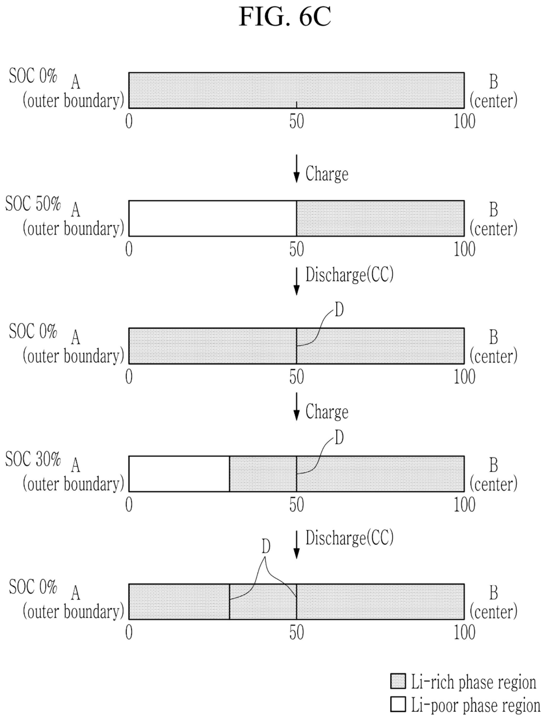

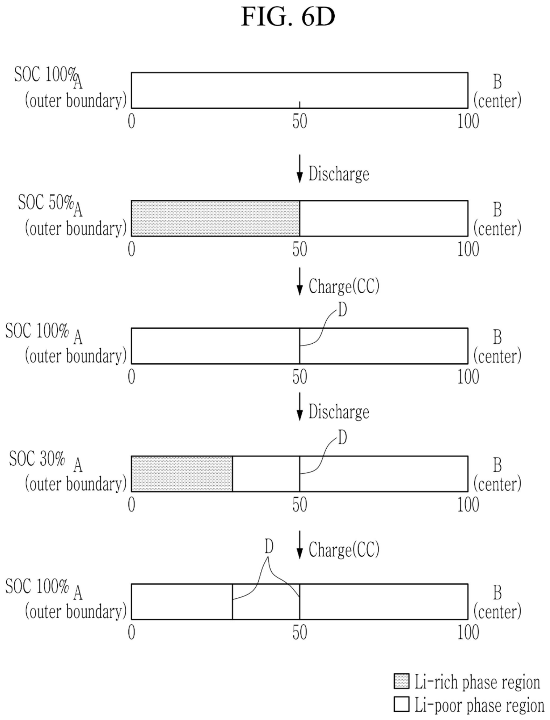

Meanwhile, depending on the charging and discharging history, a plurality of residual zones D may exist within the positive electrode active material particle. Taking FIG. 6C as an example, when the battery 20 is charged from SOC 0% to SOC 50% and then CC discharged back to SOC 0%, and afterwards charged to SOC 30% and then CC discharged back to SOC 0%, the residual zone D may be formed when discharged from SOC 50% to SOC 0% and when discharged from SOC 30% to SOC 0%. Taking FIG. 6D as an example, when the battery 20 is discharged from SOC 100% to SOC 50% and then CC charged back to SOC 100%, and afterwards discharged to SOC 30% and then CC charged back to SOC 100%, the residual zone D may be formed when charged from SOC 50% to SOC 100% and when charged from SOC 30% to SOC 100%, respectively.

FIG. 7A and FIG. 7B are drawings for explaining a method by which the lithium condition estimator 131 detects a residual zone based on a lithium ion distribution status.

In a CC discharge section, the position information (the starting position and the ending position) of each Li-rich phase region may be continuously estimated. When two or more Li-rich phase regions exist within the positive electrode active material particle, the lithium condition estimator 131 may estimate a relative distance (distance in one-dimensional coordinate system) between the neighboring two Li-rich phase regions based on the position information of each Li-rich phase region.

Taking FIG. 7A as an example, as the battery 20 is CC discharged from SOC 50% to SOC 20%, the Li-rich phase region R(1) may be newly generated in the outer boundary of the positive electrode active material particle. Accordingly, the two Li-rich phase regions R(1) and R(2) may exist within the positive electrode active material particle. The lithium condition estimator 131 may continuously estimate the position information of these two Li-rich phase regions R(1) and R(2). In addition, the lithium condition estimator 131 may estimate a relative distance between the two Li-rich phase regions R(1) and R(2), based on the position information of each of the Li-rich phase regions R(1) and R(2). The lithium condition estimator 131 may estimate, the relative distance between the two Li-rich phase regions R(1) and R(2), by using a value (S(2) - E(1)) obtained by subtracting an ending position E(1) of the later-generated the Li-rich phase region R(1) (located on the outer boundary of the positive electrode active material particle) from a starting position S(2) of the first-generated the Li-rich phase region R(2) (located on the center of the positive electrode active material particle) among the two Li-rich phase regions R(1) and R(2).

When the relative distance (S(2) - E(1)) between the two Li-rich phase regions R(1) and R(2) decreases to be below a threshold value by CC discharge, the lithium condition estimator 131 may determine that the residual zone D is formed between the two Li-rich phase regions R(1) and R(2). When it is determined that the residual zone D is formed between the two Li-rich phase regions R(1) and R(2), the lithium condition estimator 131 may record the starting position E(1) of the residual zone D in the storage device 11. The lithium condition estimator 131 may continuously detect the starting position E(1) of the residual zone D until the relative distance (S(2) - E(1)) between the two Li-rich phase regions R(1) and R(2) becomes 0, and update information recorded in the storage device 11. When the relative distance (S(2) - E(1)) between the two Li-rich phase regions R(1) and R(2) becomes 0, the lithium condition estimator 131 may detect the boundary (E(1) or S(2)) between the two Li-rich phase regions R(1) and R(2) as the starting position of the residual zone D, and update information recorded in the storage device 11.

When the CC discharge continues for a predetermined time or more or the CV discharge proceeds after the relative distance (S(2) - E(1)) between the two Li-rich phase regions R(1) and R(2) becomes 0, the lithium condition estimator 131 may determine that the residual zone D has been resolved. Accordingly, the lithium condition estimator 131 may delete the position information of the residual zone D from the storage device 11. In addition, the lithium condition estimator 131 may determine that the two Li-rich phase regions R(1) and R(2) are combined to form the one Li-rich phase region R(1), and may update the position information of the Li-rich phase region R(1).

On the other hand, when CC discharging is interrupted while it is determined that the residual zone D remains, the lithium condition estimator 131 may maintain the position information of the residual zone D stored in the storage device 11. Taking FIG. 7A as an example, the lithium condition estimator 131 may estimate that the residual zone D remains at a boundary of the two Li-rich phase regions R(1) and R(2), as discharging of the battery 20 is interrupted since the SOC of the battery 20 has reached 0%. Therefore, the lithium condition estimator 131 may maintain position information E(1) of the residual zone D detected at SOC 0% as recorded in the storage device 11.

The residual zone D generated during CC discharging may be eliminated when charging continues and lithium ions are sufficiently released from the residual zone D.

Taking FIG. 7A as an example, in a charge section after the CC discharge, the battery 20 may be charged to SOC 80%. When charging is initiated, lithium ions begin to be deintercalated from the Li-rich phase region R(1), so that the Li-rich phase region R(1) may be gradually transitioned to the Li-poor phase region P(1). Afterwards, when charging further progresses and the SOC of the battery 20 becomes 50%, the Li-rich phase region R(1) that was located on the outer boundary side may lose all lithium ions, thereby being transitioned to the Li-poor phase region P(1). In addition, lithium ions may begin to be released from the residual zone D. Accordingly, the lithium condition estimator 131 may change the Li-rich phase region R(2) that was located in the center of the positive electrode active material particle to the Li-rich phase region R(1), may change the position information S(2) and E(2) of the Li-rich phase region R(2) to position information S(1) and E(1) of the new the Li-rich phase region R(1), and store them in the storage device 11. In addition, the lithium condition estimator 131 may delete the position information S(2) and E(2) of the conventional the Li-rich phase region R(2) from the storage device 11.

Afterwards, as charging progresses further, that is, when the SOC of the battery 20 increases to be above 50%, the residual zone D may lose all lithium ions thereby being transitioned to the Li-poor phase region P(1), and lithium ions may begin to be released from the remaining Li-rich phase region R(1). Therefore, the lithium condition estimator 131 may delete the position information of the residual zone D from the storage device 11.

In the CC charge section, the lithium condition estimator 131 may continuously estimate the position information of each Li-poor phase region P(i). When two or more Li-poor phase regions exist within the positive electrode active material particle, the lithium condition estimator 131 may estimate a relative distance (distance in one-dimensional coordinate system) between the neighboring two Li-poor phase regions based on the position information of each Li-poor phase region. Subsequently, when the relative distance between the two Li-poor phase regions decreases to be below the threshold value by CC charge, the lithium condition estimator 131 may determine that the residual zone is formed between the two Li-poor phase regions.

Meanwhile, as shown in FIG. 7B, when the lithium condition estimator 131 records the lithium ion distribution status within the positive electrode active material particle, if a method of recording the position information of each Li-rich phase region is used, the lithium condition estimator 131 may detect that the residual zone is formed in the boundary portion between the two Li-poor phase regions, based on location information of the Li-rich phase region located between the two Li-poor phase regions.

Taking FIG. 7B as an example, as the battery 20 is CC charged from SOC 50% to SOC 80%, the Li-poor phase region P(1) may be newly generated in the outer boundary of the positive electrode active material particle. Accordingly, the two Li-poor phase regions P(1) and P(2) may exist within the positive electrode active material particle, and the Li-rich phase region R(1) is located between the two Li-poor phase regions P(1) and P(2). The lithium condition estimator 131 may continuously estimate the position information S(1) and E(1) of the Li-rich phase region R(1). In addition, the lithium condition estimator 131 may calculate a relative distance between the Li-poor phase regions P(1) and P(2), based on the position information S(1) and E(1) of the Li-rich phase region R(1). The lithium condition estimator 131 may estimate the relative distance between the two Li-poor phase regions P(1) and P(2) from a difference between the starting position S(1) and the ending position E(1) of the Li-rich phase region R(1), i.e., a width of the Li-rich phase region R(1).

When the relative distance (E(1) - S(1)) between the two Li-poor phase regions P(1) and P(2) decreases to be below the threshold value by CC charge, the lithium condition estimator 131 may determine that the residual zone D is formed between the two Li-poor phase regions P(1) and P(2). When it is determined that the residual zone D is formed between the two Li-poor phase regions P(1) and P(2), the lithium condition estimator 131 may record the starting position S(1) of the residual zone D in the storage device 11. The lithium condition estimator 131 may continuously detect the starting position S(1) of the residual zone D until the relative distance (E(1) - S(1)) between the two Li-poor phase regions P(1) and P(2) becomes 0 and update information recorded in the storage device 11. When the relative distance (E(1) - S(1)) between the two Li-poor phase regions P(1) and P(2) becomes 0, the lithium condition estimator 131 may update the position information of the residual zone D, by recording the boundary E(1) or S(1) between the two Li-poor phase regions P(1) and P(2) in the storage device 11 as the starting position of the residual zone D.

When the CC charge continues for a predetermined time or more or the CV charge proceeds after the relative distance (E(1) - S(1)) between the two Li-poor phase regions P(1) and P(2) becomes 0, the lithium condition estimator 131 may determine that the residual zone D has been resolved. Accordingly, the lithium condition estimator 131 may delete the position information of the residual zone D from the storage device 11. In addition, the lithium condition estimator 131 may determine that the two Li-poor phase regions P(1) and P(2) are combined to form the one Li-poor phase region P(1), and may update the position information of the Li-poor phase region P(1).

On the other hand, the CC charge is stopped while the residual zone D still remains, the lithium condition estimator 131 may maintain the position information of the residual zone D stored in the storage device 11. Taking FIG. 7B as an example, the lithium condition estimator 131 may determine that the residual zone D still remains at the boundary of the two Li-poor phase regions P(1) and P(2), as the CC charge is stopped since the SOC of the battery 20 has reached 100%, and may not delete the position information E(1) or S(1) of the residual zone D from the storage device 11.

The residual zone D generated during CC charging may be eliminated when lithium ions are sufficiently intercalated into the residual zone D by discharging.

Taking FIG. 7B as an example, in a discharge section after the CC charge, the battery 20 may be discharged to SOC 20%. When discharging is initiated, lithium ions may begin to be intercalated into the Li-poor phase region P(1), and the Li-poor phase region P(1) may gradually transition to the Li-rich phase region R(1). Afterwards, when discharging further progresses and the SOC of the battery 20 becomes 50%, the Li-poor phase region P(1) that was located on the outer boundary side may sufficiently obtain lithium ions to be transitioned to the Li-rich phase region R(1), and lithium ions may also begin to be intercalated into the residual zone D.

Afterwards, as discharging progresses further, that is, when the SOC of the battery 20 becomes lower than 50%, the residual zone D may also sufficiently obtain lithium ions to be transitioned to the Li-rich phase region R(1), and lithium ion may begin to be intercalated into the remaining Li-poor phase region P(1). Accordingly, the lithium condition estimator 131 may delete the position information of the residual zone D from the storage device 11.

When recording the position information of the residual zone D, the lithium condition estimator 131 may also record the corresponding SOC in the storage device 11 by mapping them. The lithium condition estimator 131 may predict the SOC at which intercalation or deintercalation of lithium ions is initiated in the residual zone D by charging or discharging, and may store this in the storage device 11 together with the position information of the residual zone D. As shown in FIG. 7A and FIG. 7B, when the distribution status of lithium ions within the positive electrode active material particle is modeling by using the bar graph, it may be seen that the ratio occupied by the Li-poor phase region within the positive electrode active material particle (the ratio occupied by the Li-poor phase region on the bar graph) is proportional to the SOC of the battery 20. Therefore, the lithium condition estimator 131 may predict the SOC of the battery 20 (hereinafter, referred to as 'memory point') at the time point at which intercalation or deintercalation of lithium ions is initiated in the residual zone D, based on a present SOC, present position information of LI-poor phase region within the positive electrode active material particle, and present position information of the residual zone D of the battery 20.

The residual zone D formed in the boundary portion between two identical-phase regions may cause a change of the activation energy barrier, thereby generating the additional overvoltage.

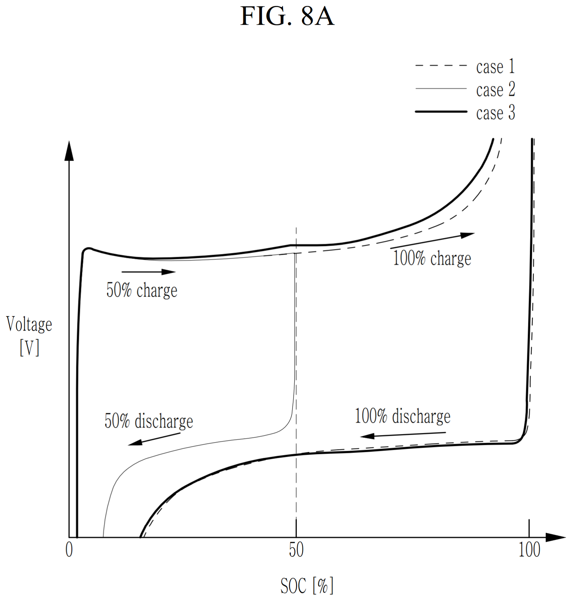

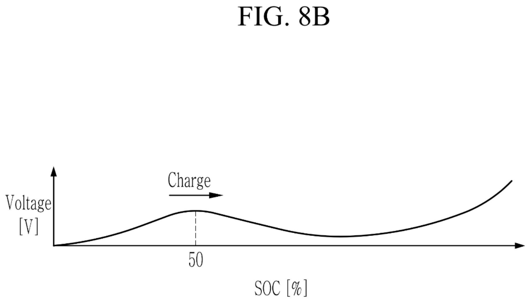

FIG. 8A and FIG. 8B are drawing for explaining a tendency for overvoltage to occur due to a residual zone.

In FIG. 8A, case1 illustrates a voltage curve of the case in which the battery 20 is charged from SOC 0% to SOC 100%, and then discharged back from SOC 100% to SOC 0%, in the normal state (the residual zone does not exist). In addition, case2 illustrates a voltage curve of the case where the battery 20 is charged from SOC 0% to SOC 50%, and then discharged back from SOC 50% to SOC 0%, after case1 has been performed. In addition, case3 illustrates a voltage curve of the case where the battery 20 is charged from SOC 0% to SOC 100%, and then discharged back from SOC 100% to SOC 0%, after case2 has been performed.

As described with reference to FIG. 6A, after progressing case2, the residual zone located in the boundary portion between the two Li-rich phase regions may be formed within the positive electrode active material particle of the battery 20. Accordingly, compared to case1 without the residual zone, in case3 performed while the residual zone exists, the additional overvoltage may be added to the voltage of the battery 20.

FIG. 8B is a voltage curve representing the additional overvoltage (i.e., voltage increase) caused by the residual zone in the charge section of case3. The voltage curve of FIG. 8B may be derived from a voltage difference between the voltage curve in the charge section of case3 and the voltage curve in the charge section of case1.

As discussed herein, the lithium condition estimator 131 may model the distribution status of lithium ions according to the SOC with respect to one positive electrode active material particle, and detect the position of respective phase regions and residual zones in the positive electrode active material particle. However, the positive electrode of the actual battery 20 may include the plurality of positive electrode active material particles. When the positive electrode includes the plurality of positive electrode active material particles, the time point at which the residual zone occurs within that particle, and the time point at which intercalation/deintercalation of lithium ions occurs in the residual zone may vary depending on the position of each positive electrode active material particle.

Accordingly, as shown in FIG. 8B, the additional overvoltage curve caused by the residual zone of the positive electrode active material particles in the battery 20 may appear as a shape similar to normal distribution curve in a wide SOC range.

In addition, the residual zone may decrease the effective capacity of the battery 20, and accordingly, the overvoltage may continuously appear to increase until the battery 20 is fully charged. Due to these characteristics, in some SOC ranges, as shown in FIG. 8B, the additional overvoltage curve may appear in a shape similar to an exponential function.

Based on the characteristics described herein, the additional overvoltage curve caused by the residual zone in the battery 20 may be defined by using two overvoltage functions, that is, a normal distribution function and an exponential function.

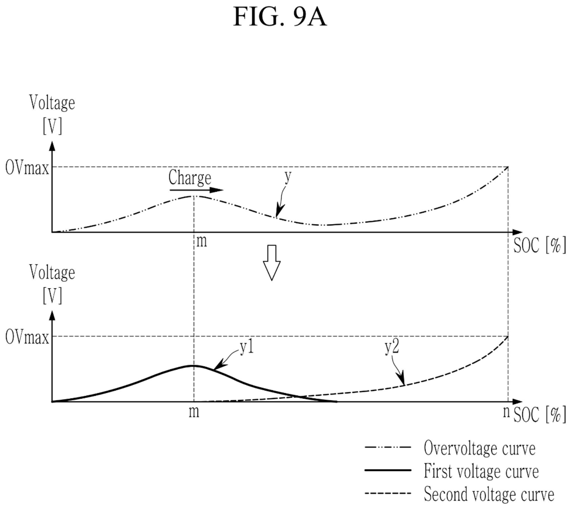

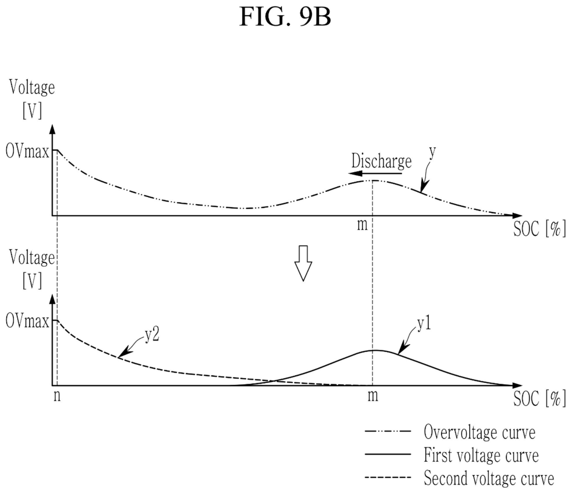

FIG. 9A and FIG. 9B show examples of defining an additional overvoltage occurring due to a residual zone by using two voltage curves, where FIG. 9A represents the overvoltage curve in the charge section, and FIG. 9B represents the overvoltage curve in the discharge section. Referring to FIG. 9A, in the charge section of the battery 20, the overvoltage in the shape of the normal distribution curve may occur in the low SOC range, and afterwards, the overvoltage in the shape of the exponential function curve that gradually increases as the SOC increases may occur. Referring to FIG. 9B, in the discharge section of the battery 20, the overvoltage in the shape of the normal distribution curve may occur in the high SOC range, and afterwards, the overvoltage in the shape of the exponential function curve that increases as the SOC decrease may occur.

In FIG. 9A and FIG. 9B, the additional overvoltage curve y caused by the residual zone in the battery 20 may be defined as a sum (y = y1+y2) of two voltage curves (a first voltage curve y1 and a second voltage curve y2).

The first voltage curve y1 may correspond to the additional overvoltage that occurs due to the change of the activation energy barrier by the residual zone within the positive electrode active material particle, and may be defined by using a normal distribution function f1(x) of Equation 1 below.

[Equation 1]

$$y1 = f1(x) = \frac{1}{\sqrt{2\pi}\sigma}e^{-\frac{(x-m)^2}{2\sigma^2}}$$

With respect to the case in FIG. 8A where case2 and case3 are sequentially performed, when the lithium ion distribution status within the positive electrode active material particle is modeled by the method illustrated in FIG. 7A, the residual zone D may be generated within the positive electrode active material particle as case2 progresses. In addition, when case3 progresses afterwards and the battery 20 is charged to around SOC 50%, lithium ion begins to be released from the residual zone D, which may change the activation energy barrier. Referring to FIG. 8A and FIG. 8B, it may be seen that, even in the overvoltage curve of the battery 20 where the plurality of positive electrode active material particles are distributed within the positive electrode, the portion of normal distribution curve has symmetry centered around SOC 50%.

Therefore, in Equation 1 above, m, which represents the center (or average) of the normal distribution, may use the memory point recorded by the lithium condition estimator 131. According to what is described herein, when recording the position of the residual zone D, the lithium condition estimator 131 may predict the SOC at which lithium ions begin to be intercalated or deintercalated in the residual zone D, afterwards, and may store the predicted SOC in the storage device 11 as the memory point.

In Equation 1 above, x may represent the present SOC, and $\sigma$ may represent the spread of the normal distribution curve y1. σ may be experimentally determined in advance, and may be determined through fitting of the normal distribution curve y1 and the actual overvoltage curve y of the battery 20.

The second voltage curve y2 may correspond to the additional overvoltage that occurs due to a decrease of the effective capacity of the battery 20 by the residual zone, and may be defined by using exponential function f2(x) of Equation 2 below.

[Equation 2]

$$y2 = f2(x) = OVmax \times \frac{(a^x - a^m)}{(a^n - a^m)}$$

In Equation 2 above, OVmax may represent a maximum value of the overvoltage that additionally occurs by the residual zone, m may represent the memory point recorded by the lithium condition estimator 131, n may represent the SOC at which OVmax occurs, a may correspond to the base of the exponential function, and x may represent the present SOC. OVmax, a and n may be experimentally determined in advance, and may be determined through fitting of exponential function f2(x) and the actual overvoltage curve y of the battery 20.

Referring to FIG. 9A, in the second voltage curve y2 at the time of charging the battery 20, it may be set that a > 1, since the voltage value increases as the SOC increases. Referring to FIG. 9B, in the second voltage curve y2 at the time of discharging the battery 20, it may be set that 0 < a < 1, since the voltage value decreases as the SOC increases.

Referring to FIG. 9A, the additional overvoltage caused by the residual zone in the battery 20 during charging may be estimated by using the normal distribution function f1(x) and the exponential function f2(x) in the SOC range that satisfies 0 < the SOC < n. In addition, referring to FIG. 9B, the additional overvoltage caused by the residual zone in the battery 20 during discharging may be estimated by using the normal distribution function f1(x) and the exponential function f2(x) in the SOC range that satisfies n < the SOC < 100.

Referring back to FIG. 2, the overvoltage functions (the normal distribution function f1(x) and the exponential function f2(x)) described herein may be calibrated to the voltage behavior of the battery 20 through a preliminary experiment, and then stored in a function table 112 of the storage device 11.

The behavior of the additional overvoltage caused by the residual zone may vary depending on the charging and discharging condition (temperature, the SOH, the position of the residual zone (or memory point), or the like, of the battery 20). Therefore, through the preliminary experiment, the overvoltage functions (the normal distribution function f1(x) and the exponential function f2(x) may be generated for each charging and discharging condition, and each charging and discharging condition and the overvoltage functions (the normal distribution function f1(x) and the exponential function f2(x) corresponding thereto may be stored in the function table 112.

Referring back to FIG. 2, when it is estimated by the lithium condition estimator 131 that the residual zone exists within the positive electrode active material particle, the corrector 132 may fetch the overvoltage functions (the normal distribution function f1(x) and the exponential function f2(x) matching the present charging and discharging condition from the function table 112. The corrector 132 may calculate the overvoltage value corresponding to the present SOC, by using the overvoltage functions (the normal distribution function f1(x) and the exponential function f2(x) fetched from the function table 112. When the overvoltage functions corresponding to the present charging and discharging condition are not found from the function table 112, the corrector 132 may also fetch the overvoltage functions of the charging and discharging condition most similar to the present charging and discharging condition from the function table 112. In this case, the corrector 132 may correct the overvoltage functions fetched from the function table 112, to be suitable for the present charging and discharging condition, by a method such as interpolation.

When the overvoltage value is calculated, the corrector 132 may generate a correction parameter (a correction resistance, or a correction voltage) by using this. The corrector 132 may correct the battery model 111, by combining the generated correction parameter with the battery model 111.

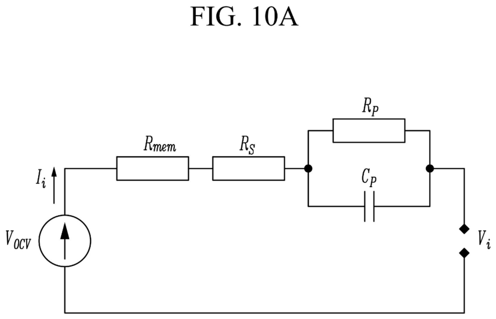

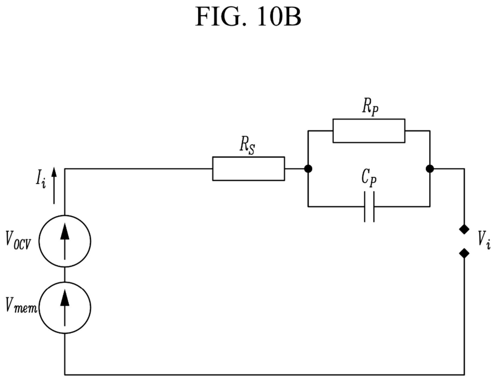

FIG. 10A and FIG. 10B are drawings for explaining methods by which the corrector 132 corrects the battery model 111.

Referring to FIG. 10A, when the overvoltage value corresponding to the present SOC is calculated, the corrector 132 may obtain a correction resistance Rmem, by dividing the calculated overvoltage value by a current measurement value of the battery 20. The corrector 132 may correct the battery model 111, by adding the obtained correction resistance Rmem as an internal parameter of the battery model 111. That is, the corrector 132 may add the correction resistance Rmem as a resistance connected between the series resistance Rs and the open circuit voltage (OCV) Vocv.

Referring to FIG. 10B, when the overvoltage value corresponding to the present SOC is calculated, the corrector 132 may correct the battery model 111, by adding this into the battery model 111 as a correction voltage Vmem. That is, the corrector 132 may add the correction voltage Vmem in the battery model 111, so that it is connected in series with the open circuit voltage (OCV) Vocv.

Referring back to FIG. 2, the battery condition estimator 133 may determine the condition value of the battery 20 by using the battery model 111 corrected by the corrector 132 and the measurement values of the measuring device 12. That is, the battery condition estimator 133 may estimate the internal impedance Rs, Rp, and Cp, the open circuit voltage (OCV) Vocv, the SOH, or the like, of the battery 20 by using the corrected battery model 111 as well as the current measurement value and a voltage measurement value. The battery condition estimator 133 may also correct the SOC of the battery 20 by using the battery model 111. For example, the battery condition estimator 133 may estimate the SOC of the battery 20 by using the measurement values measured from the battery 20, and afterwards, may correct the SOC by using the corrected battery model 111. In addition, the battery condition estimator 133 may detect abnormalities such as an internal short circuit and degradation of the battery 20 based on the condition value of the battery 20. In addition, when an abnormality of the battery 20 is detected, the battery condition estimator 133 may perform a protective function of the battery 20 such as blocking of the charging and discharging current.

The control device 13 may include at least one processor for performing the functions (functions of the lithium condition estimator 131, the corrector 132, and the battery condition estimator 133) mentioned in this specification of the control device 13. The processor may refer to a data processing device having a physically structured circuit to perform a function expressed by code or instructions included in a program, such as a microprocessor, a central processing unit (CPU), a processor core, a multiprocessor, an application-specific integrated circuit (ASIC), a field programmable gate array (FPGA), and the like.

The control device 13 may be integrated into the battery management system (BMS) of the battery system 1.

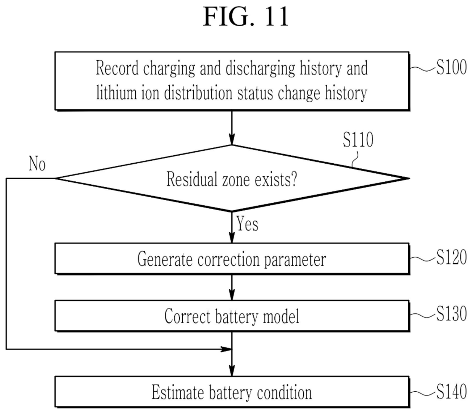

FIG. 11 schematically shows a method for detecting a battery condition according to embodiments. The method of FIG. 11 may be performed by the control device 13 described with reference to FIG. 2 to FIG. 10B.

Referring to FIG. 11, the control device 13 may record the charging and discharging history, and the history of changes in the distribution status of lithium ions within the positive electrode active material particle of the battery 20, at step S100.

At the step S100, the charging and discharging history may include a history of changes in the SOC of the battery 20. The control device 13 record the charging and discharging history of the battery 20, by continuously detecting the SOC of the battery 20, and store the detected SOC in a time series in the storage device 11.

At the step S100, a lithium ion distribution status within the positive electrode active material particle may be estimated based on the SOC of the battery 20. The control device 13 may model the inside of the positive electrode active material particle by using one-dimensional coordinate system in the bar graph format described with reference to FIG. 3C and FIG. 3D, and may estimate position information of the Li-rich phase region and the Li-poor phase region within one-dimensional coordinate system that vary according to the SOC. When the position information of the Li-rich phase region and the Li-poor phase region is determined, the control device 13 may store it in the storage device 11 by mapping with the corresponding SOC.

At the step S100, the control device 13 may detect generation of the residual zone, based on the position information of the Li-rich phase region and the Li-poor phase region. When it is determined that the residual zone is generated, the control device 13 may record the position information of the residual zone in the storage device 11. In addition, the control device 13 may predict the memory point corresponding to the residual zone, and may record the predicted memory point together in the storage device 11.

At step S110, when it is determined that the residual zone exists within the positive electrode active material particle, the control device 13 may generate the correction parameter for reflecting the overvoltage caused by the residual zone into the battery model 111, at step S120.

At the step S120, the control device 13 may fetch the overvoltage functions (the normal distribution function f1(x) and the exponential function f2(x)) corresponding to the present charging and discharging condition (temperature, the SOH, and the position of the residual zone (or memory point) of the battery 20)) from the function table 112. The control device 13 may calculate the overvoltage value corresponding to the present SOC, by using the overvoltage functions fetched from the function table 112. When the overvoltage value is calculated, the control device 13 may generate the correction parameter (the correction resistance, or the correction voltage) by using this.

When the correction parameter is generated, the control device 13 may correct the battery model 111 by combining the correction parameter to the battery model 111, at step S130.

At the step S130, the control device 13 may add the correction resistance Rmem as a resistance connected between the series resistance Rs and the open circuit voltage (OCV) Vocv inside the battery model 111. The control device 13 may add the correction voltage Vmem in the battery model 111, so that it is connected in series with the open circuit voltage (OCV) Vocv.

When the battery model 111 is corrected, the control device 13 may estimate a condition of the battery 20 by using the corrected battery model 111, at step S140.

At the step S140, the control device 13 may estimate the internal impedance Rs, Rp, and Cp, the open circuit voltage (OCV) Vocv, the SOH, or the like, of the battery 20 by using the corrected battery model 111 as well as the current measurement value and the voltage measurement value. The control device 13 may estimate the SOC of the battery 20 by using the battery model 111. For example, the control device 13 may estimate the SOC of the battery 20 by using the measurement values measured from the battery 20, and afterwards, may correct the SOC by using the corrected battery model 111. In addition, the control device 13 may detect abnormalities such as an internal short circuit and degradation of the battery 20 by using the corrected battery model 111.

The herein-described embodiments can be realized through a program for realizing functions corresponding to the configuration of the embodiments or a recording medium for recording the program in addition to through the herein-described device and/or method, which is easily realized by a person skilled in the art. The computer-readable recording medium may include all types of recording devices for storing data that can be read by a computer system. Examples of computer-readable recording device may include ROM, RAM, CD-ROM, DVD_ROM, DVD_RAM, magnetic tape, floppy disks, hard disks, and optical data storage devices.

While this disclosure has been described in connection with what is presently considered to be practical embodiments, it is to be understood that the disclosure is not limited to the disclosed embodiments, but, on the contrary, is intended to cover various modifications and equivalent arrangements included within the spirit and scope of the appended claims.

## Claims

1. A device for detecting a battery condition (10), comprising:

   a storage device (11) storing a battery model (111) that models a voltage change and an internal impedance of a battery (20) as an electrical circuit; and
   a control device (13) configured to estimate a distribution status of lithium ions within a positive electrode active material of the battery (11), detect a distortion zone remaining in a boundary portion of two identical-phase regions in the positive electrode active material based on the distribution status, estimate an overvoltage caused by the distortion zone, correct the battery model (111) by using a correction parameter corresponding to the overvoltage, and estimate a condition of the battery (20) by using the battery model (111).

2. The device (10) as claimed in claim 1, wherein:

   the positive electrode active material comprises $LiFePO_4$;
   the distribution status comprises a distribution status within a positive electrode active material particle of a Li-rich phase region (R(i)) comprising a $Li_xFePO_4$ ($x \geq 0.9$) phase and a Li-poor phase region (P(i)) comprising a $Li_yFePO_4$ ($y \leq 0.05$) phase; and
   the two identical-phase regions are two Li-rich phase regions (R(i)) or two Li-poor phase regions (P(i)).

3. The device (10) as claimed in claim 2, wherein the control device (13) is configured to:

   model a region between an outer boundary and a center of the positive electrode active material particle as a one-dimensional coordinate system;
   estimate position information within the positive electrode active material particle of the Li-rich phase region (R(i)) and the Li-poor phase region (P(i)) by using the one-dimensional coordinate system.

4. The device (10) as claimed in claim 3, wherein the control device (13) is configured to:

   estimate a first distance between the two Li-rich phase regions (R(i)), or a second distance between the two Li-poor phase regions (P(i)) based on the position information;
   determine that the distortion zone is formed in a boundary portion between the two Li-rich phase regions (R(i)), if the first distance decreases below a threshold value during a constant current discharge; and
   determine that the distortion zone is formed in a boundary portion between the two Li-poor phase regions (P(i)), if the second distance decreases below the threshold value during a constant current charge,
   optionally wherein the control device (13) is configured to determine that the distortion zone has been eliminated, if the distortion zone exists in a boundary portion of the two Li-rich phase regions (R(i)), if the distortion zone is completely transitioned to the Li-rich phase region (R(i)) by discharging or the distortion zone is transitioned to the Li-poor phase region (P(i)) by charging.

5. The device (10) as claimed in claim 4, wherein the control device (13) is configured to determine that the distortion zone has been eliminated, if the distortion zone exists in a boundary portion of the two Li-poor phase regions (P(i)), or if the distortion zone is completely transitioned to the Li-poor phase region (P(i)) by charging, or if the distortion zone is completely transitioned to the Li-rich phase region (R(i)) by discharging.

6. The device (10) as claimed in claim 4 or 5, wherein the control device (13) is configured to:

   estimate the position information of the distortion zone by using the one-dimensional coordinate system; and
   predict a state-of-charge (SOC) at which lithium ions are deintercalated from or intercalated into the distortion zone in a subsequent charge or discharge section, based on the position information of the distortion zone.

7. The device (10) as claimed in claim 6, wherein:

   the control device (13) is configured to determine the overvoltage by using a first overvoltage estimated by using a first overvoltage function and a second overvoltage estimated by using a second overvoltage function;
   the first overvoltage function is a normal distribution function centered on the SOC, which derives the first overvoltage occurring in the distortion zone for each SOC of the battery (20); and
   the second overvoltage function is an exponential function, which derives the second overvoltage occurring in the distortion zone for each SOC of the battery (20), optionally wherein the storage device (11) is configured to store a function table (112) comprising a plurality of first overvoltage functions and a plurality of second overvoltage functions corresponding to different charging and discharging conditions; and
   the control device (13) is configured to select the first overvoltage function and the second overvoltage function from the function table (112) depending on a present charging and discharging condition of the battery (20).

8. The device (10) as claimed in any of the preceding claims, wherein:

   the correction parameter comprises a correction resistance or a correction voltage; and
   the control device (13) is configured to add the correction resistance or the correction voltage to internal parameters of the battery model (111).

9. A method for detecting a battery (20) condition, the method comprising:

   recording a distribution status of lithium ions within a positive electrode active material according to a charging and discharging history of the battery (20);
   detecting a distortion zone remaining in a boundary portion of two identical-phase regions in the positive electrode active material based on the distribution status;
   estimating an overvoltage caused by the distortion zone;
   correcting a battery model (111) of the battery (20) by using a correction parameter corresponding to the overvoltage; and
   estimating a condition of the battery (20) by using the battery model (111),
   wherein the battery model (111) models a voltage change and an internal impedance of the battery (20) as an electrical circuit.

10. The method as claimed in claim 9, wherein:

    the positive electrode active material comprises $LiFePO_4$;
    the distribution status comprises a distribution status within a positive electrode active material particle of a Li-rich phase region (R(i)) comprising a $Li_xFePO_4$ ($x \geq 0.9$) phase and a Li-poor phase region (P(i)) comprising a $Li_yFePO_4$ ($y \leq 0.05$) phase; and
    the two identical-phase regions are two Li-rich phase regions (R(i)) or two Li-poor phase regions (P(i)).

11. The method as claimed in claim 10, wherein the recording comprises estimating position information within the positive electrode active material particle of the Li-rich phase region (R(i)) and the Li-poor phase region (P(i)) by using one-dimensional coordinate system modeling a region between an outer boundary and a center of the positive electrode active material particle.

12. The method as claimed in claim 11, wherein the detecting the distortion zone comprises:

    estimating a first distance between the two Li-rich phase regions (R(i)), or a second distance between the two Li-poor phase regions (P(i)) based on the position information;
determining that the distortion zone is formed in a boundary portion between the two Li-rich phase regions (R(i)), if the first distance decreases below a threshold value during a constant current discharge; and
determining that the distortion zone is formed in a boundary portion between the two Li-poor phase regions (P(i)), if the second distance decreases below the threshold value during a constant current charge.

13. The method as claimed in claim 12, further comprising determining that the distortion zone has been eliminated, if the distortion zone exists in a boundary portion of the two Li-rich phase regions (R(i)), if the distortion zone is completely transitioned to the Li-rich phase region (R(i)) by discharging or the distortion zone is transitioned to the Li-poor phase region (P(i)) by charging, optionally further comprising determining that the distortion zone has been eliminated, if the distortion zone exists in a boundary portion of the two Li-poor phase regions (P(i)), or if the distortion zone is completely transitioned to the Li-poor phase region (P(i)) by charging or if the distortion zone is completely transitioned to the Li-rich phase region (R(i)) by discharging.

14. The method as claimed in claim 12 or 13, further comprising:

estimating the position information of the distortion zone by using the one-dimensional coordinate system; and predicting a SOC at which lithium ions are deintercalated from or intercalated into the distortion zone in a subsequent charge or discharge section, based on the position information of the distortion zone, optionally wherein the estimating the overvoltage comprises:

estimating a first overvoltage by using a first overvoltage function;
estimating a second overvoltage by using a second overvoltage function; and
determining the overvoltage by adding the first overvoltage and the second overvoltage,
wherein the first overvoltage function is a normal distribution function centered on the SOC, which derives the first overvoltage occurring in the distortion zone for each SOC of the battery (20), and
wherein the second overvoltage function is an exponential function, which derives the second overvoltage occurring in the distortion zone for each SOC of the battery (20).

15. The method as claimed in any of the claims 9 to 14, wherein:

the correction parameter comprises a correction resistance or a correction voltage; and
the correcting comprises correcting the battery model (111) by adding the correction resistance or the correction voltage to internal parameters of the battery model (111).

# FIG. 1

# FIG. 2

# FIG. 3A

Li-rich phase region
Li-poor phase region

FIG. 3B

Li-rich phase region
Li-poor phase region

# FIG. 3C

Positive electrode
active material particle

Positive electrode
active material particle

Li⁺

Charge

A
(outer boundary)

B
(center)

0  20  40  60  80  100

A
(outer boundary)

B
(center)

0  20  40  60  80  100

▨ Li-rich phase region
☐ Li-poor phase region

EP 4 760 857 A2

FIG. 3D

# FIG. 4A

# FIG. 4B

# FIG. 4C

SOC 50%  A
(outer boundary)

P(1)  R(1)  P(2)

B
(center)

0  20  40  60  80  100

Discharge 5%

SOC 45%  A
(outer boundary)

R(1)  P(1)  R(2)  P(2)

B
(center)

0  20  40  60  80  100

Discharge 10%

SOC 35%  A
(outer boundary)

R(1)  P(1)

B
(center)

0  20  40  60  80  100

☒ Li-rich phase region
☐ Li-poor phase region

# FIG. 4D

Discharge 5%

Discharge 10%

Li-rich phase region
Li-poor phase region

EP 4 760 857 A2

# FIG. 5A

Li-rich phase region
Li-poor phase region

29

## FIG. 5B

SOC 40%
A (outer boundary)

S(1) E(1)          S(2)                    E(2)

B (center)

0    20    40    60    80    100

R(1)      P(1)           R(2)

Charge 5%

SOC 45%
A (outer boundary)

S(1) E(1)          S(2)                    E(2)

B (center)

0    20    40    60    80    100

P(1)   R(1)      P(2)              R(2)

Charge 10%

SOC 55%
A (outer boundary)

S(1)                    E(1)

B (center)

0    20    40    60    80    100

P(1)              R(1)

⬚ Li-rich phase region
☐ Li-poor phase region

# FIG. 5C

SOC 50%
A (outer boundary)
B (center)

S(1)    E(1)
0    20    40    60    80    100
P(1)    R(1)    P(2)

Discharge 5%

SOC 45%
A (outer boundary)
B (center)

S(1) E(1) S(2)    E(2)
0    20    40    60    80    100
R(1)    P(1)    R(2)    P(2)

Discharge 10%

SOC 35%
A (outer boundary)
B (center)

S(1)    E(1)
0    20    40    60    80    100
R(1)    P(1)

☐ Li-rich phase region
☐ Li-poor phase region

## FIG. 5D

FIG. 6A

# FIG. 6B

1st charge section

SOC 50%

A (outer boundary) 0 R(1) 50 P(1) 100 B (center)

↓Charge(CC)

SOC 80%

A (outer boundary) 0 P(1) R(1) 50 P(2) 100 B (center)

↓Charge(CC)

SOC 100%

A (outer boundary) 0 P(1) 50 D P(2) 100 B (center)

1st discharge section

SOC 100%

A (outer boundary) 0 P(1) 50 D P(2) 100 B (center)

↓Discharge

SOC 80%

A (outer boundary) 0 R(1) P(1) 50 D P(2) 100 B (center)

↓Discharge

SOC 50%

A (outer boundary) 0 R(1) 50 D P(1) 100 B (center)

↓Discharge

SOC 20%

A (outer boundary) 0 R(1) 50 P(1) 100 B (center)

↓Discharge

SOC 0%

A (outer boundary) 0 R(1) 50 100 B (center)

2nd charge section

SOC 0%

A (outer boundary) 0 R(1) 50 100 B (center)

↓Charge

SOC 100%

A (outer boundary) 0 P(1) 50 100 B (center)

▨ Li-rich phase region
☐ Li-poor phase region

EP 4 760 857 A2

## FIG. 6C

SOC 0% A (outer boundary) — B (center)
0    50    100

↓ Charge

SOC 50% A (outer boundary) — B (center)
0    50    100

↓ Discharge(CC)

D

SOC 0% A (outer boundary) — B (center)
0    50    100

↓ Charge

D

SOC 30% A (outer boundary) — B (center)
0    50    100

↓ Discharge(CC)

D

SOC 0% A (outer boundary) — B (center)
0    50    100

▨ Li-rich phase region
☐ Li-poor phase region

# FIG. 6D

SOC 100%
(outer boundary)     A ............................................... B (center)
                     0            50            100

↓ Discharge

SOC 50%
(outer boundary)     A ............................................... B (center)
                     0            50            100

↓ Charge(CC)

SOC 100%
(outer boundary)     A ............... D ............... B (center)
                     0            50            100

↓ Discharge

SOC 30%
(outer boundary)     A ............... D ............... B (center)
                     0            50            100

D ↓ Charge(CC)

SOC 100%
(outer boundary)     A ............................................... B (center)
                     0            50            100

▨ Li-rich phase region
□ Li-poor phase region

FIG. 7A

# FIG. 7B

1st charge section

S(1)　　　E(1)

SOC 50%

A | [Li-rich] | [Li-poor] | B (center)
(outer boundary) 0 — R(1) — 50 — P(1) — 100

↓ Charge(CC)

S(1) E(1)

SOC 80%

A | [Li-poor] | [Li-rich] | [Li-poor] | B (center)
(outer boundary) 0 — P(1) — R(1) — 50 — P(2) — 100

↓ Charge(CC)

SOC 100%

A | [Li-poor] D | [Li-poor] | B (center)
(outer boundary) 0 — P(1) — 50 — P(2) — 100

▨ Li-rich phase region
☐ Li-poor phase region

⟹

1st discharge section

SOC 100%

A | [Li-poor] D | [Li-poor] | B (center)
(outer boundary) 0 — P(1) — 50 — P(2) — 100

↓ Discharge

S(1) E(1)

SOC 80%

A | [Li-rich] | [Li-poor] D | [Li-poor] | B (center)
(outer boundary) 0 — R(1) — P(1) — 50 — P(2) — 100

↓ Discharge

S(1)　　　E(1)

SOC 50%

A | [Li-rich] | [Li-poor] D | [Li-poor] | B (center)
(outer boundary) 0 — R(1) — 50 D P(1) — 100

↓ Discharge

S(1)　　　　　　E(1)

SOC 20%

A | [Li-rich] | [Li-poor] | B (center)
(outer boundary) 0 — R(1) — 50 — P(1) — 100

# FIG. 8A

case 1
case 2
case 3

100% charge

50% charge

Voltage
[V]

50% discharge

100% discharge

0        50        100

SOC [%]

FIG. 8B

# FIG. 9A

## FIG. 9B

## FIG. 10A

FIG. 10B

## FIG. 11

```
┌─────────────────────────────────────────────┐
│ Record charging and discharging history and  │──S100
│ lithium ion distribution status change history│
└─────────────────────────────────────────────┘
                      │
                      ▼
         S110
No   ◇─────────────────────────────◇
◄────  Residual zone exists?
      ◇─────────────────────────────◇
                      │ Yes
                      ▼
┌─────────────────────────────────────────────┐
│         Generate correction parameter         │──S120
└─────────────────────────────────────────────┘
                      │
                      ▼
┌─────────────────────────────────────────────┐
│             Correct battery model             │──S130
└─────────────────────────────────────────────┘
                      │
                      ▼
┌─────────────────────────────────────────────┐
│           Estimate battery condition          │──S140
└─────────────────────────────────────────────┘
```